# EUROPEAN PATENT APPLICATION

(11) **EP 4 848 961 A1**
(43) Date of publication of application: **02.12.2026**
(21) Application number: 26169750.2
(22) Date of filing: 31.03.2026
(51) Int. Cl.: H10K 71/20, H10K 59/122, H10K 71/60

(54) **DISPLAY PANEL, METHOD OF MANUFACTURING THE SAME, AND ELECTRONIC DEVICE**

(30) Priority: 30.05.2025 KR 20250071361
(71) Applicant: Samsung Display Co., Ltd., Yongin-si, Gyeonggi-do 17113 (KR)
(72) Inventor: Seo, Kabjong, 17113 Yongin-si, Gyeonggi-do (KR); Kim, Seonil, 17113 Yongin-si, Gyeonggi-do (KR); Kim, Jeongwon, 17113 Yongin-si, Gyeonggi-do (KR); Park, Junhong, 17113 Yongin-si, Gyeonggi-do (KR); Choi, Seonhwa, 17113 Yongin-si, Gyeonggi-do (KR)
(74) Representative: Gulde & Partner

(57) **Abstract**

A display panel may include a substrate including a display area (DA) and a non-display area (PA), a display layer on the substrate, and an encapsulation layer on the display layer. The non-display area (PA) may surround at least a portion of the display area (DA) or the non-display area (PA) may be at least partially surrounded by the display area (DA). The display layer may include a first layer on the display area (DA) and the non-display area (PA). A taper angle of one surface of the first layer on the display area (DA) may be greater than a taper angle of one surface of the first layer on the non-display area (PA).

## Description

### BACKGROUND

### 1. Field

One or more embodiments relate to a device and a method, and more particularly, to a display panel, a method of manufacturing the same, and an electronic device.

### 2. Description of the Related Art

Mobile electronic devices are widely used. In addition to compact mobile devices such as mobile phones, tablet personal computers (PCs) have recently been in wide use.

To support various functions, such mobile electronic devices may include display panels that provide visual information, for example, images or videos, to users. Recently, as components used to drive display panels have become smaller, the importance of display panels in electronic devices is increasing, and structures that may be bent by a certain angle from a flat state have also been developed.

### SUMMARY

The invention is defined by the appended claims. The description that follows is subjected to this limitation. Any disclosure lying outside the scope of said claims is only intended for illustrative as well as comparative purposes.

In general, various layers may be arranged in a display panel. In this case, as various layers are stacked, upper layers above the various layers may become discontinuous depending on the outer shape (e.g., height, inclination of side surfaces, etc.) of certain layers. One or more embodiments of the present disclosure may provide a display panel that reduces discontinuities in certain layers, a method of manufacturing the display panel, and an electronic device.

Additional aspects will be set forth in part in the description which follows and, in part, will be apparent from the description, or may be learned by practice of the presented embodiments of the disclosure.

According to one or more embodiments of the disclosure, a display panel may include a substrate including a display area and a non-display area, the non-display area surrounding at least a portion of the display area or the non-display area being at least partially surrounded by the display area; a display layer on the substrate; and an encapsulation layer on the display layer. The display layer may include a first layer on the display area and the non-display area. A taper angle of one surface of the first layer on the display area may be greater than a taper angle of one surface of the first layer on the non-display area.

According to the present disclosure, the term non-display area may serve as a general term that encompasses specific embodiments such as a peripheral area, which surrounds the display area, as well as an internal non-display area, which is surrounded by the display area.

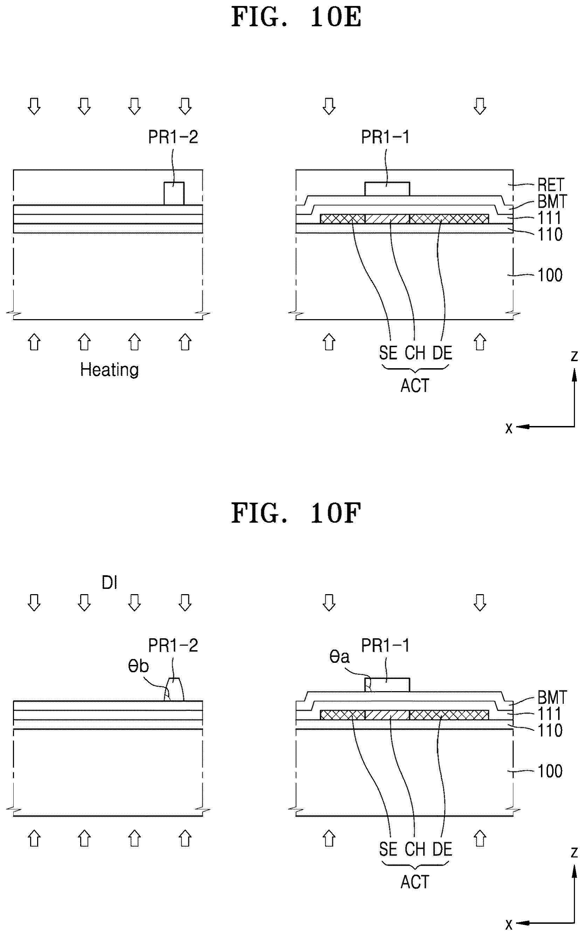

According to the present disclosure, the taper angle or inclination angle may refer to an internal angle formed between a lower surface of a structure and its inclined side surface. When viewing a cross-section of a structure, this may correspond to the angle at the base (within the material of the structure) where the side surface meets an underlying layer. A greater taper angle (e.g., θa in FIG. 10F) may correspond to a steeper, more abrupt edge, which allows for a higher packing density of components in the display area. A smaller or gentler taper angle (e.g., θb in FIG. 10F) corresponds to a shallower, more gradual edge, which improves step coverage for subsequent layers in the non-display area, thereby reducing the risk of breaks or short circuits.

It is to be understood that the feature disclosed in the embodiments, wherein a taper angle of one surface of a first layer on the display area is greater than a taper angle of one surface of the first layer on the non-display area, may represent a general principle.

This principle may be applicable to any pair of corresponding layers or structures, for example those corresponding layers or structures described below that may be formed substantially simultaneously, e. g., in a same process step such as an etching process, from a common corresponding base material. The term first layer may serve as a representative for such a layer.

According to one or more embodiments, in the context of conductive layers, the first layer on the display area may be a gate electrode or a lower capacitor electrode, while the corresponding first layer on the non-display area may be a first fanout line.

In a further embodiment, the first layer on the display area may be an upper capacitor electrode, with the corresponding first layer on the non-display area being a second fanout line.

According to one or more embodiments, for organic insulating layers, the first layer on the display area may be a contact hole, a pixel-defining opening, or the spacer, while the corresponding first layer on the non-display area may be a first layer (e. g. of a dam), a second layer (e. g. of a dam), or a third layer (e. g. of the dam), respectively.

In all these cases, a corresponding manufacturing method is used to intentionally form a steeper angle in the display area to enable a higher packing density and finer patterns, while a gentler angle in the non-display area provides for improved step coverage and higher structural reliability.

According to one or more embodiments, the display panel may include a plurality of the aforementioned layers with different taper angles, which are stacked on top of each other. The principle that the taper angle in the display area is greater than in the non-display area may apply to each of these layers individually. The absolute values of the taper angles may differ from one layer to the next, for instance, due to different materials or process conditions. For example, the taper angle of the gate electrode in the display area may be a different value than the taper angle of the contact hole in the display area. Alternatively, in other embodiments, the taper angles for different stacked layers may also be substantially the same. For instance, the taper angle of the gate electrode and the taper angle of the upper capacitor electrode may be configured to have identical values. Regardless of whether the angles between the different layers are the same or different, the core principle may be maintained that for each individual layer, its respective angle in the display area is greater than the angle of its corresponding structure in the non-display area.

In some embodiments, the first layer may include an insulating material, a conductive material, or both the insulating material and the conductive material.

In some embodiments, the display panel may further include a dam on the non-display area and the dam may include the first layer.

In some embodiments, the display layer may include an organic insulating layer on the display area. The first layer of the dam may include a same material as the organic insulating layer on the display area, and a taper angle of an inclined surface of the first layer may be less than a taper angle of an inclined surface of the organic insulating layer.

According to one or more embodiments of the disclosure, a method of manufacturing the display panel may include arranging a first base layer on a substrate, the substrate including a display area and a non-display area, the non-display area surrounding at least a portion of the display area or the non-display area being at least partially surrounded by the display area; arranging photoresist on the first base layer; forming the photoresist into patterns of the photoresist spaced apart from each other; irradiating ultraviolet light onto the photoresist on the non-display area and applying a shrinkage-inducing material over the photoresist on the display area and the non-display area; applying heat to the shrinkage-inducing material and then removing the shrinkage-inducing material from the photoresist; and heating the photoresist.

According to the present disclosure, the term first base layer used in the method according to one or more embodiments may be understood as a general designation for any starting layer that is patterned using the disclosed method.

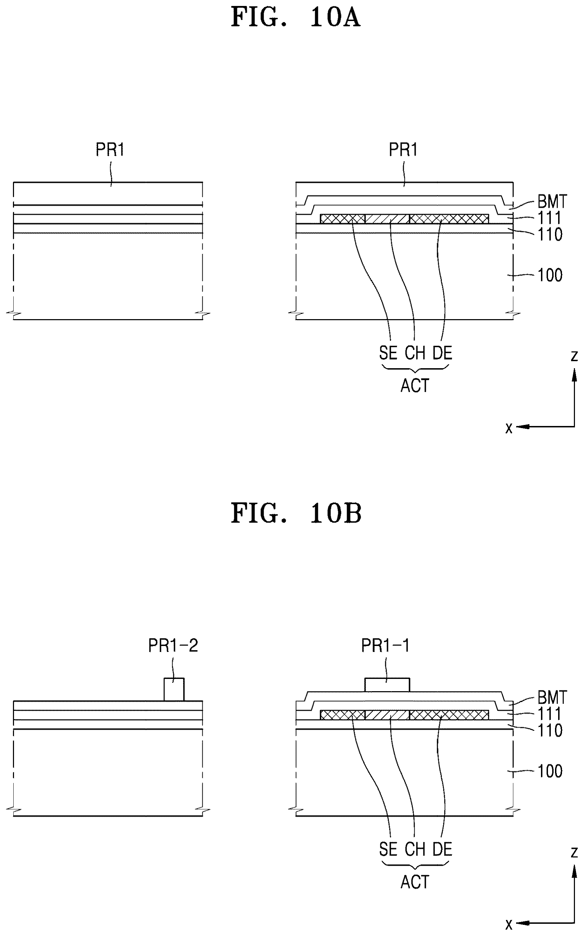

According to one embodiment, for example, where conductive structures are formed, the first base layer may refer to a conductive layer, for example the conductive first base layer (e.g., BMT from FIGS. 10A-10G) that is used to form the gate electrode and the first fanout line.

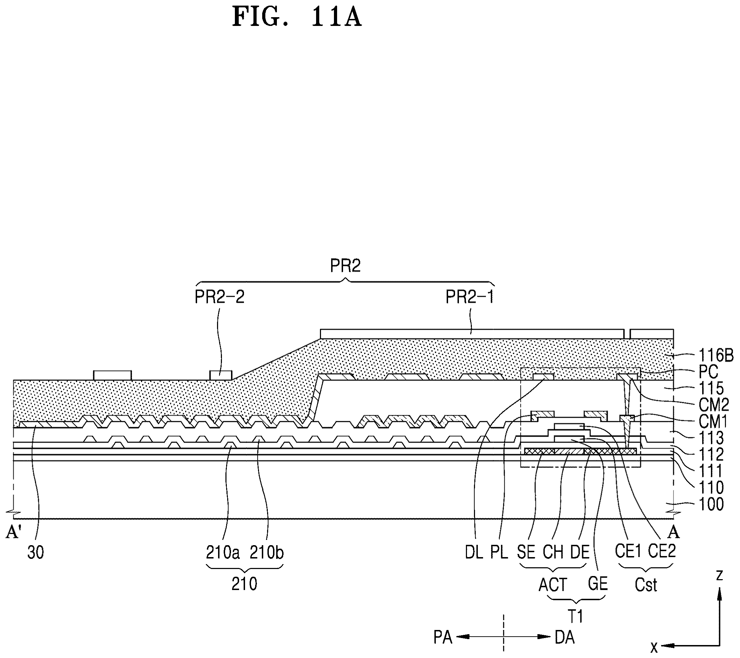

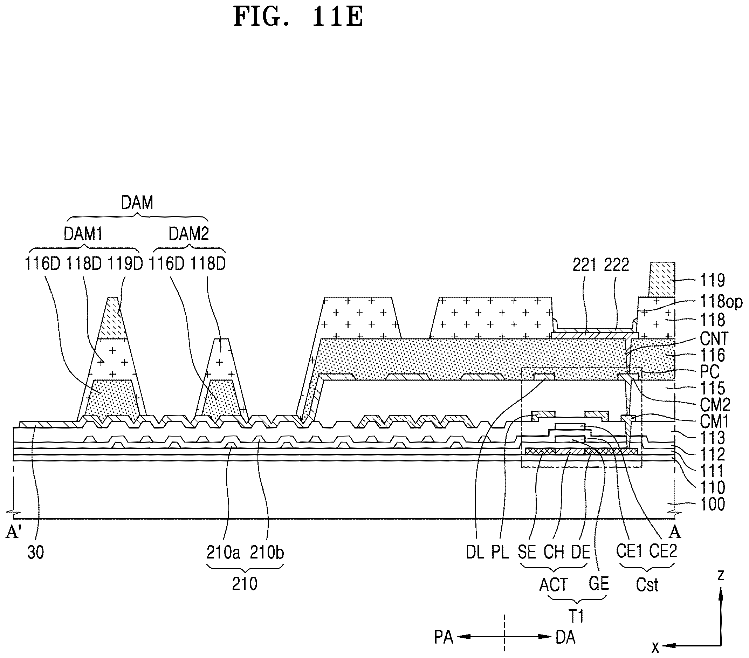

According to one embodiment, where organic structures are formed, the same term first base layer may refer to an organic layer, for example the organic second base layer (e.g., the second base layer 116B from FIGS. 11A-11E) described below that is used to form the contact hole and the first layer (of the dam).

It is further understood that to form the other corresponding layer pairs, such as the upper capacitor electrode and the second fanout line, or the spacer and the third layer of the dam, the disclosed method may be analogously applied to further base layers of the respective material. Therefore, the term first base layer encompasses all such starting layers.

This highlights that the disclosed method is universally applicable to different materials and can be used for forming any one or more layers of the display panel, without being limited to a specific sequence or number of applications.

According to the present disclosure, the terms used in the method, such as first base layer and first layer, may describe a general and repeatable manufacturing process. Through this method, in which a first base layer is etched using a specially shaped mask, a first layer having the desired different taper angles of the display panel according to embodiments of the disclosure is formed. This resulting first layer may be the structural feature disclosed in embodiments of the display panel.

The first base layer may refer to various starting materials, for example, a conductive layer for manufacturing electrodes and lines, or an organic insulating layer for manufacturing dam structures. The first layer formed by the method may therefore be the resulting, patterned layer. This resulting layer may be one of the specific layers already explained in the context of the display panel as being the first layer with different taper angles.

According to one or more embodiments, in the context of conductive layers, the first layer on the display area produced by the method may be the gate electrode or the lower capacitor electrode, while the corresponding first layer on the non-display area may be the first fanout line.

According to one or more embodiments, the first layer on the display area may be the upper capacitor electrode, with the corresponding first layer on the non-display area being the second fanout line.

According to one or more embodiments, for organic insulating layers, the first layer on the display area may be the contact hole, the pixel-defining opening, or the spacer, while the corresponding first layer on the non-display area produced in the same process step may be the first layer (e. g. of a dam), the second layer (e. g. of a dam), or the third layer (e. g. of the dam), respectively.

The disclosed method thus may serve as a universal method to create the desired different angular profiles in the various layers of the display panel.

In some embodiments, the shrinkage-inducing material may be rinsed using ultrapure water and then removed.

In some embodiments, the removing the shrinkage-inducing material from the photoresist may include: removing the shrinkage-inducing material from the photoresist on the display area and removing some of the shrinkage-inducing material from the photoresist on the non-display area such that a portion of the shrinkage-inducing material may remain on the photoresist on the non-display area before the heating the photoresist.

In some embodiments, a first inclination angle of a surface of the photoresist on the display area may be different from a second inclination angle of a surface of the photoresist on the non-display area.

In some embodiments, the first inclination angle may be greater than the second inclination angle.

In some embodiments, the method may further include forming a first layer by etching the first base layer, wherein at least a portion of the first layer is spaced apart from another portion of the first layer.

In some embodiments, the method may further include removing the photoresist.

In some embodiments, a taper angle of a surface of the first layer arranged in the display area may be different from a taper angle of a surface of the first layer arranged in the non-display area.

In some embodiments, the method may further include arranging an encapsulation layer on the display area.

In some embodiments, the method may further include arranging an input detection layer on the encapsulation layer, the input detection layer including at least one electrode.

In some embodiments, the first layer may be formed by dry-etching the first base layer.

In some embodiments, the method may further include arranging a second base layer on the first layer and forming a second layer by removing a portion of the second base layer.

According to one or more embodiments of the disclosure, an electronic device may include a display panel configured to display an image; and a battery connected to the display panel. The display panel may include a substrate including a display area and a non-display area, the non-display area surrounding at least a portion of the display area or the non-display area being at least partially surrounded by the display area, a display layer on the substrate, and an encapsulation layer on the display layer. The display layer may include a first layer on the display area and the non-display area. A taper angle of one surface of the first layer on the display area may be greater than a taper angle of one surface of the first layer on the non-display area.

In some embodiments, the first layer may include an insulating material, a conductive material, or both the insulating material and the conductive material.

In some embodiments, the electronic device may further include a dam on the non-display area. The dam may include the first layer.

In some embodiments, the display layer may include an organic insulating layer on the display area. The first layer of the dam may include a same material as the organic insulating layer on the display area, and a taper angle of an inclined surface of the first layer may be less than a taper angle of an inclined surface of the organic insulating layer.

Other aspects, features, and advantages other than those described above will become apparent from the following detailed description, claims and drawings for carrying out the disclosure.

The general and specific aspects may be implemented by using a system, a method, a computer program, or any combination thereof.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a block diagram of an electronic device according to an embodiment;
FIGS. 2 to 4 schematically illustrate electronic devices according to various embodiments;
FIG. 5 is a schematic perspective view of a portion of a display panel according to an embodiment;
FIG. 6A is a schematic perspective view of a display panel according to an embodiment;
FIG. 6B is a schematic perspective view of a display panel according to an embodiment;
FIG. 7 is a schematic plan view of a display panel according to an embodiment;
FIG. 8 is a schematic circuit diagram of a sub-pixel circuit of a sub-pixel arranged in a display area shown in FIG. 7;
FIG. 9 is a cross-sectional view of the display panel, taken along a line A-A' of FIG. 7;
FIGS. 10A to 10H are schematic cross-sectional views illustrating a manufacturing sequence for a portion of the display panel of FIG. 9;
FIGS. 11A to 11E are schematic cross-sectional views illustrating a manufacturing sequence for a portion of the display panel of FIG. 9;
FIG. 11F is a schematic plan view of a portion of the display panel of FIG. 9;
FIG. 12 is a cross-sectional view of the display panel, taken along a line B-B' of FIG. 7;
FIG. 13 is a schematic plan view of a portion of a display panel according to another embodiment; and
FIG. 14 is a cross-sectional view of the display panel, taken along a line IV-IV' of FIG. 13.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Throughout the disclosure, the expression "at least one of a, b, or c" indicates only a, only b, only c, both a and b, both a and c, both b and c, all of a, b, and c, or variations thereof.

As the disclosure allows for various changes and numerous embodiments, particular embodiments will be shown in the drawings and described in detail in the written description. The attached drawings for illustrating embodiments of the disclosure are referred to in order to gain a sufficient understanding of the present disclosure, the merits thereof, and the objectives accomplished by the implementation of the disclosure. The disclosure may, however, be embodied in many different forms and should not be construed as being limited to the embodiments set forth herein.

Hereinafter, one or more embodiments of the disclosure will be described in detail with reference to the accompanying drawings. Like reference numerals in the drawings denote like elements, and repeated descriptions thereof are omitted.

It will be understood that although the terms "first," "second," etc. may be used herein to describe various elements, these elements should not be limited by these terms, and these elements are only used to distinguish one element from another.

As used herein, the singular forms "a," "an," and "the" are intended to include the plural forms as well, unless the context clearly indicates otherwise.

It will be further understood that the terms "comprises" and/or "comprising" used herein specify the presence of stated features or components, but do not preclude the presence or addition of one or more other features or components.

It will be understood that when a layer, region, or element is referred to as being "formed on" another layer, region, or element, it can be directly or indirectly formed on the other layer, region, or element. That is, for example, intervening layers, regions, or elements may be present.

Sizes of elements in the drawings may be exaggerated for convenience of explanation. In other words, since sizes and thicknesses of elements in the drawings are arbitrarily illustrated for convenience of explanation, the following embodiments are not limited thereto.

In the following examples, the x-axis, the y-axis and the z-axis are not limited to three axes of the rectangular coordinate system, and may be interpreted in a broader sense. For example, the x-axis, the y-axis, and the z-axis may be perpendicular to one another, or may represent different directions that are not perpendicular to one another.

When a certain embodiment may be implemented differently, a specific process order may be performed differently from the described order. For example, two consecutively described processes may be performed substantially at the same time or performed in an order opposite to the described order.

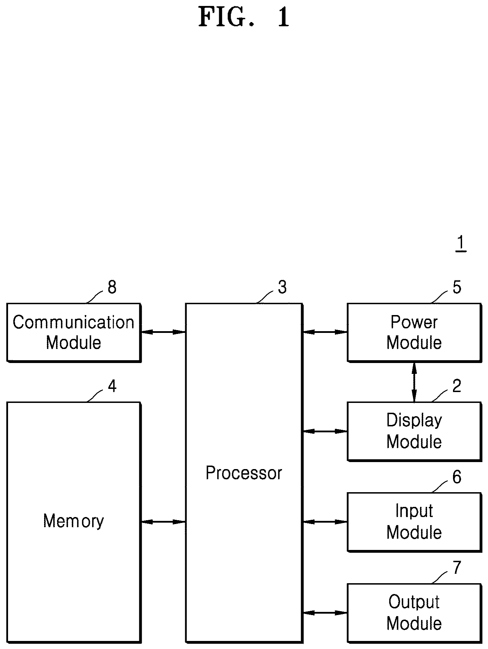

FIG. 1 is a block diagram of an electronic device according to an embodiment.

Referring to FIG. 1, an electronic device 1 according to an embodiment may include a display module 2 (e.g., hardware display device), a processor 3, memory 4, and a power module 5 (e.g., hardware power device), wherein the display module 2 may include a display panel described below.

The processor 3 may include at least one of a Central Processing Unit (CPU), an Application Processor (AP), a Graphics Processing Unit (GPU), a Communication Processor (CP), an Image Signal Processor (ISP), and a controller. In an embodiment, the processor 3 may be divided into at least two processors from a functional or structural perspective. For example, the processor 3 may include a main processor in the form of a first driving chip, which includes a CPU, and an auxiliary processor in the form of a second driving chip, which includes a controller that receives an image signal from the main processor and processes the same to conform to the interface specifications of the display module 2.

The memory 4 may include at least one of non-volatile memory and volatile memory. Data information required for the operation of the processor 3 or the display module 2 may be stored in the memory 4. When the processor 3 executes an application stored in the memory 4, an image data signal and/or an input control signal may be transmitted to the display module 2, and the display module 2 may process such signals to output image information through a display screen.

The power module 5 may include a power supply module, such as a power adaptor or a battery device, and a power conversion module that generates power required for the operation of the electronic device 1 by converting the power supplied by the power supply module. The power conversion by the power conversion module may include DC-DC conversion, AC-DC conversion, and DC-AC conversion, but is not limited thereto.

The electronic device 1 may further include an input module 6 (e.g., hardware input device), an output module 7 (e.g., non-image output module such as a hardware non-image output device), and/or a communication module 8 (e.g., hardware communication device).

The input module 6 may provide input information to the processor 3 and/or the display module 2. The input module 6 may include a physical button, a keyboard, a microphone, and various other sensor modules. Examples of sensor modules may include a touch sensor, a pressure sensor, a range sensor, a position sensor, a digitizer, a motion recognition sensor, a camera sensor, a light-receiving sensor, a photoelectric transformation sensor, a temperature sensor and may also include biosensors, such as a blood pressure sensor, a blood sugar sensor, an electrocardiogram (ECG) sensor, and a heart rate sensor.

The non-image output module 7 may serve to receive information other than images from the processor 3 and to provide the same to users. Examples of the non-image output module 7 may include, for example, a sound module, a haptic module, a light-emitting module, or the like and may further include device-specific functional modules, such as a cooling module of a refrigerator.

The communication module 8 may be a module configured to exchange information between the electronic device 1 and an external device, and may include a receiver and a transmitter. The communication module 8 may include various wireless communication modules, such as a mobile communication module, a Wi-Fi module, or a Bluetooth module, or various wired communication modules.

At least one of the components of the electronic device 1 described above may be included in a display device including the display panel according to the one or more embodiments described below. In addition, some of individual modules functionally included in a single module may be included in the display device, and others thereof may be provided separately from the display device. For example, the display device may include the display module 2, and the processor 3, the memory 4, and the power module 5 may be provided as different devices within the electronic device 1, rather than being part of the display device. As another example, the power module 5 may be provided in the display device and supply power to the processor 3 and the memory 4 provided in the electronic device 1, rather than in the display device, but one or more embodiments are not limited thereto.

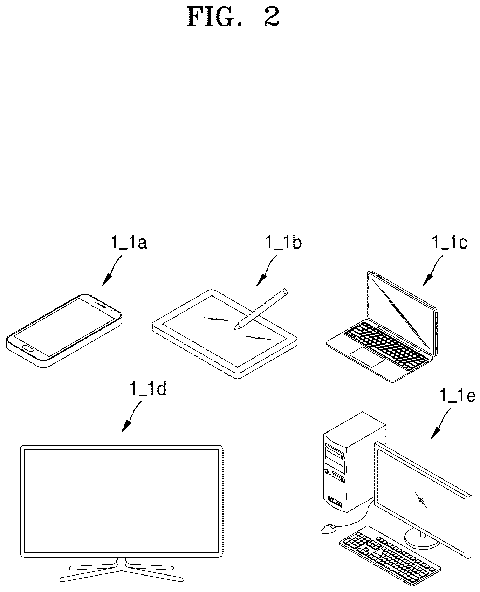

FIGS. 2 to 4 schematically illustrate electronic devices according to various embodiments.

FIG. 2 illustrates a smartphone 1_1a, a tablet personal computer (PC) 1_1b, a laptop 1_1c, a television (TV) 1_1d, and a desktop monitor 1_1e as examples of electronic devices according to various embodiments.

The smartphone 1_1a may include an input module, such as a touch sensor, and a communication module, in addition to the display module 2. The smartphone 1_1a may process information received through the communication module or other input modules, thus displaying the information through the display module of the display device.

Similar to the smartphone 1_1a, the tablet PC 1_1b, the laptop 1_1c, the TV 1_1d, and the desktop monitor 1_1e may also include display modules and input modules and may further include communication modules in some cases.

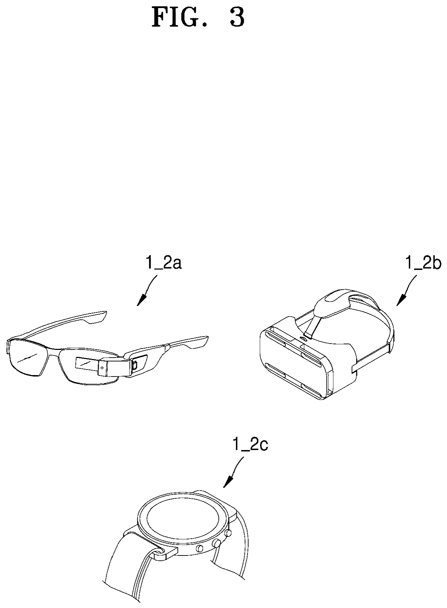

FIG. 3 illustrates an example in which an electronic device including a display module is applied to a wearable electronic device. The wearable electronic device may be smart glasses 1_2a, a head-mounted display 1_2b, a smart watch 1_2c, or the like.

The smart glasses 1_2a and the head-mounted display 1_2b may each include a display module that emits a display image and a reflector that reflects the emitted display image to the user's eyes, and through this configuration, a screen for virtual reality or augmented reality may be provided to the user.

The smart watch 1_2c may include a biosensor as an input device and provide biometric information acquired through the biosensor to the user via the display module.

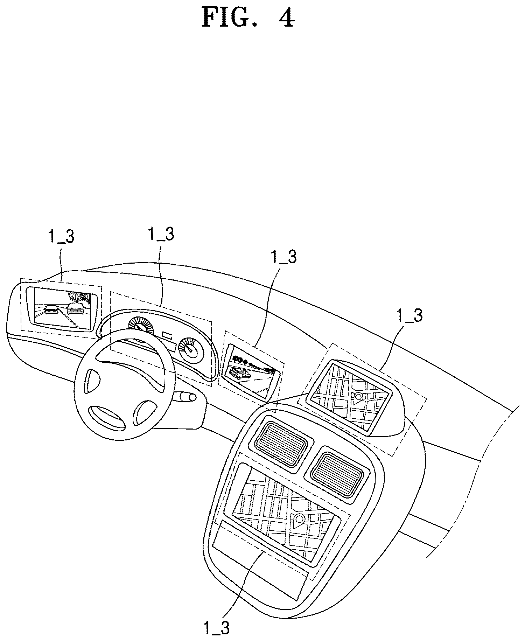

FIG. 4 illustrates an example in which an electronic device including a display module is applied to a vehicle. For example, the electronic device 1_3 may be applied to a vehicle instrument cluster, a center fascia, a Center Information Display (CID) mounted on a dashboard of a vehicle or a room-mirror display configured to replace side-view mirrors.

Although not shown, the electronic device, to which the display device according to embodiments are applied, may include not only devices mainly for image display, such as billboards, electronic display boards, and game machines, but also various home appliances, such as refrigerators, washing machines, dryers, air conditioners, and robot vacuum cleaners, which display information through display modules. In addition, when the display module has a function for transmitting light, the display module may be applied to an electronic device, such as a smart window or a transparent display device for displaying an image together with a background. The types of the electronic devices according to an embodiment are not limited to the examples above and may also be applied to various electronic devices that are not shown.

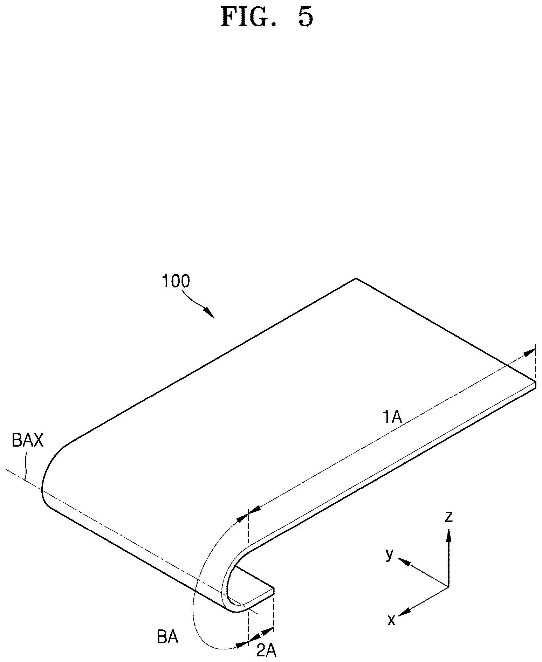

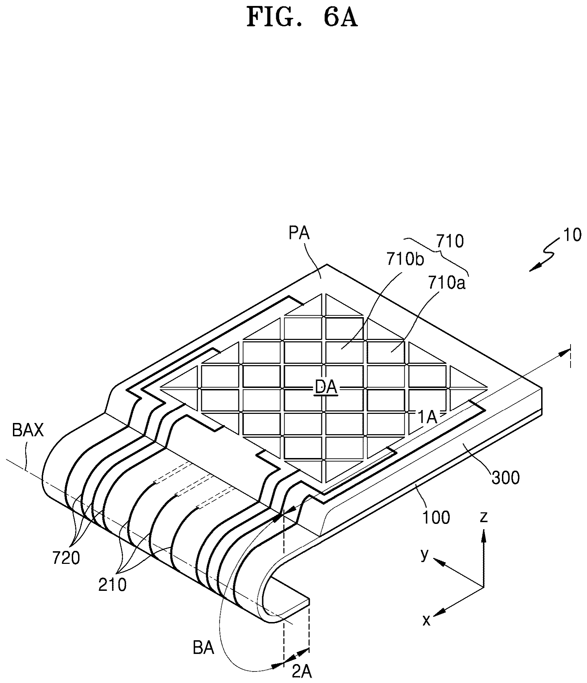

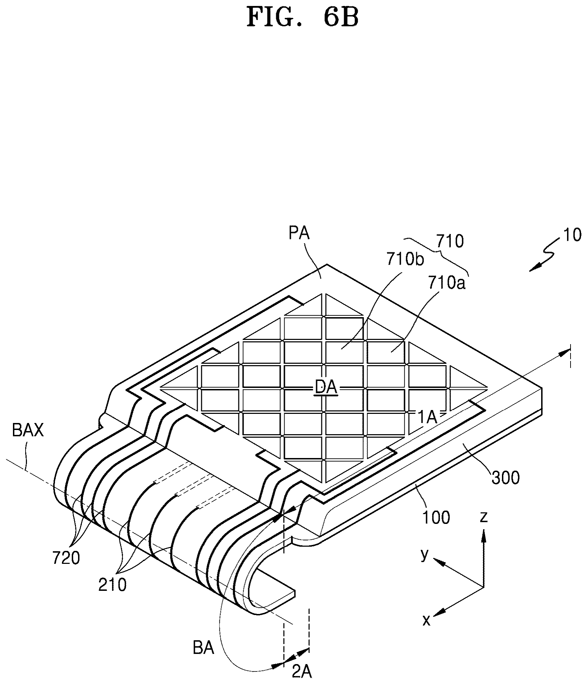

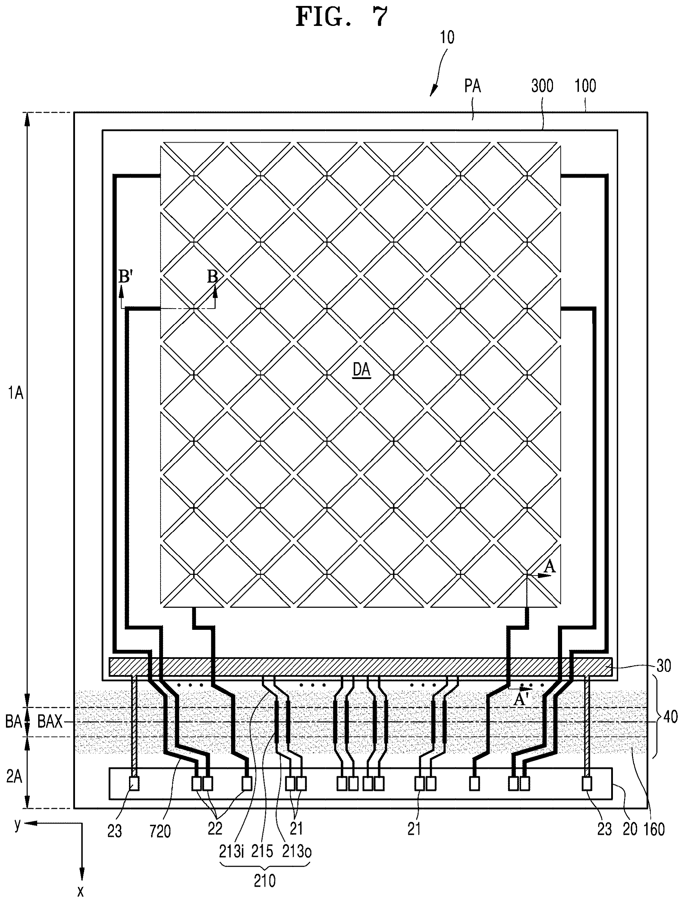

FIG. 5 is a schematic perspective view of a portion of a display panel according to an embodiment. FIG. 6A is a schematic perspective view of the display panel according to an embodiment. FIG. 6B is a schematic perspective view of the display panel according to an embodiment. FIG. 7 is a schematic plan view of the display panel according to an embodiment.

Referring to FIGS. 5 to 7, the display panel is a panel for displaying an image and may be implemented as, for example, a liquid crystal display panel, an electrophoretic display panel, an organic light emitting display panel, an inorganic light emitting display panel, a field emission display panel, a surface-conduction electron-emitter display panel, a plasma display panel, or a cathode ray display panel.

Hereinafter, a case where a display panel is an organic light-emitting display panel is described, but one or more embodiments are not limited thereto. Display panels of various types may be used.

As shown in FIG. 5, in the display panel according to the present embodiment, a portion of a substrate 100, which is a portion of the display panel, may be bent, and accordingly, a portion of the display panel may have a bent shape matching the bending of the substrate 100. However, for convenience of explanation, FIG. 7 illustrates that the display panel is not bent. For reference, in the cross-sectional views or plan views of the embodiments described below, the display panel is illustrated in an unbent state for convenience of illustration.

As shown in FIGS. 5 to 6B, the substrate 100 included in the display panel according to the present embodiment may be divided into a display area DA, where display elements are provided and images are displayed, and a peripheral area PA outside the display area DA. The peripheral area PA includes a bending area BA that is bent with respect to the bending axis BAX. The bending area BA may refer to an area having a radius of curvature after bending. The peripheral area PA may be a non-display area where no images are displayed.

FIGS. 5 and 6A illustrate that the shape of the substrate 100 is substantially a rectangle (or rectangular) and a portion of the substrate 100 is bent, but one or more embodiments are not limited thereto. As shown in FIG. 6B, the substrate 100 may have a partially rounded portion between the bending area BA and the display area DA, along the periphery of the display area DA. That is, the width of one side of the substrate 100 may be different from that of the opposite side. FIG. 6B illustrates that the width of one side of the substrate 100 in a first direction (x direction) is different from that of the opposite side. To implement such a shape, laser cutting may be performed on the substrate 100. The shape of the substrate 100 may take various forms. The substrate 100 may have various shapes, such as a circle, an oval, and a polygon, as a whole.

As shown in FIGS. 5 to 7, the substrate 100 included in the display panel according to the present embodiment may have the bending area BA extending in a second direction (y direction). The bending area BA may be located between a first area 1A and a second area 2A in the first direction (x direction) intersecting the second direction. For example, as shown in FIG. 5, the substrate 100 may be bent with respect to the bending axis BAX extending in the second direction (y direction). FIG. 5 illustrates that the substrate 100 is bent with a uniform radius of curvature with respect to the bending axis BAX, but one or more embodiments are not limited thereto. The substrate 100 may be bent with a non-uniform radius of curvature with respect to the bending axis BAX. The substrate 100 may include various materials having flexible or bendable properties, and examples of the materials include polyethersulfone (PES), polyacrylate (PAR), polyetherimide (PEI), polyethylene naphthalate (PEN), polyethylene terepthalate (PET), polyphenylene sulfide (PPS), , polyimide (PI), polycarbonate (PC), or cellulose acetate propionate (CAP). The substrate 100 may have a single-layer structure or a multilayered structure including the above materials, and when the substrate 100 has a multilayered structure, the substrate 100 may additionally include an inorganic layer.

The first area 1A includes the display area DA. As shown in FIGS. 6A and 6B, the first area 1A includes not only the display area DA but also a portion of the peripheral area PA outside the display area DA. The second area 2A also includes the peripheral area PA.

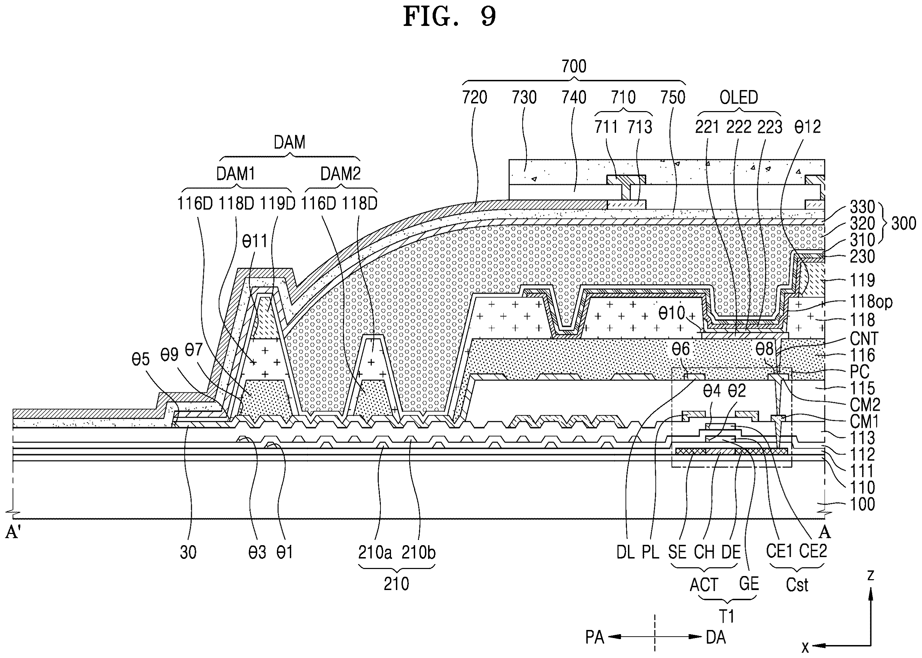

In the display area DA of the substrate 100, a plurality of sub-pixels are arranged apart from each other, thus displaying images. In the display area DA, a display layer including a thin-film transistor (TFT), an organic light-emitting diode (OLED) that is a display element, a capacitor, and/or the like may be provided. In this case, the display layer may refer to a portion ranging from a buffer layer 110 to a capping layer 230 as will be described below in FIG. 9.

The display area DA may further include not only a gate line configured to transmit a gate signal and a data line configured to transmit a data signal, both of which carry pulse signals, but also signal lines, such as a driving power line and a common power line, which carry DC signals. Sub-pixels may be formed through electrical coupling of TFTs, capacitors, and OLEDs connected to the gate line and the data line, the driving power line, and the common power line, and images may be displayed accordingly. The sub-pixel may emit light at a luminance corresponding to a driving current flowing through the OLED, in response to a data signal, based on the driving power and common power supplied to the sub-pixel. The signal lines may be connected to driving circuitry (not shown) connected to a terminal portion 20 through fanout lines 210. In other words, the fanout lines 210 may be configured to transmit a pulse signal, such as a gate signal and a data signal, and direct current, such as power. In another embodiment, although not shown in the drawings, the driving circuitry may be arranged on (e.g., formed on) the substrate 100, and the fanout lines 210 may be connected to the driving circuitry. When the driving circuitry is arranged on (e.g., formed on) the substrate 100, the driving circuitry may be arranged between the terminal portion 20 and the driving voltage supply line 30 shown in FIG. 7. As shown in the drawings, the fanout lines 210 are not limited to being arranged only on the lower surface of the substrate 100. For example, similar to the touch line of FIG. 7, the fanout line 210 may extend downward from at least one of the side surface and the upper surface of the display area DA to the lower side thereof, and may be connected to the terminal portion 20 or the driving circuitry. Some of the fanout lines 210 may intersect the touch line 720. The slope of the outer surface of the fanout line 210 may influence the sidewall angle of a dam described below, thus affecting the touch line 720 arranged on (e.g., formed on) the dam.

There may be a plurality of sub-pixels, and the sub-pixels may be arranged in various patterns, such as a stripe pattern or a Pentile pattern.

The display area DA may be sealed by an encapsulation layer 300. The encapsulation layer 300 may cover display elements, etc. arranged in the display area DA to protect the display elements, etc. from external moisture or oxygen. The encapsulation layer 300 may cover the display area DA and partially extend to the outer side of the display area DA.

On the encapsulation layer 300, an input detection layer 700 (see FIG. 9) including touch electrodes 710 having various patterns for the touchscreen function is provided. The touch electrodes 710 include a plurality of first touch electrodes 710a connected to each other in the first direction (x direction) and a plurality of second touch electrodes 710b connected to each other in the second direction (y direction) crossing the first direction.

The touch electrode 710 may include a transparent electrode material (e.g., transparent conductive oxide) so that light from emission areas of the sub-pixels arranged under the input detection layer 700 may pass through the touch electrode 710. Alternatively, the touch electrode 710 may have a mesh form to allow light from the emission areas of the sub-pixels to pass through. In this case, the material of the touch electrode 710 is not limited to the transparent electrode material. For example, the touch electrode 710 may be a layer or layers formed of a conductive material including aluminum (Al), copper (Cu), and/or titanium (Ti).

The touch electrode 710 may be connected to the touch line 720 configured to transmit a signal detected by the touch electrode 710, and the touch line 720 may extend to the peripheral area PA from the upper portion of the encapsulation layer 300 along one side surface of the encapsulation layer 300.

In the peripheral area PA, the terminal portion 20, the driving voltage supply line 30, and a wiring portion 40 may be arranged. In addition, although not shown, a common power line, a gate driver, a data driver, etc. may be further arranged in the peripheral area PA.

The terminal portion 20 may be arranged on (e.g., formed on) an end portion of the peripheral area PA and includes a plurality of terminals 21 to 23. The terminal portion 20 may not be covered by an insulating layer and may be exposed, thereby being electrically connected to a controller (not shown), such as a flexible printed circuit board or a driver Integrated Chip (IC). The controller may provide a data signal, a gate signal, the first power voltage ELVDD that is a driving voltage, the second power voltage ELVSS that is a common voltage, and the like. In addition, the controller may transmit signals to the input detection layer 700 or receive signals detected by the input detection layer 700, through the touch line 720.

The driving voltage supply line 30 may be connected to the controller through a driving terminal 22 and may provide the first power voltage ELVDD, which is provided from the controller, to the sub-pixels. The driving voltage supply line 30 may be arranged in the peripheral area PA to cover one side surface of the display area DA.

The fanout line 210 is arranged in the peripheral area PA and connected to a signal line configured to apply electrical signals to a TFT or a display element arranged in the display area DA. As described above, the signal lines may correspond to various lines, such as a gate line, a data line, a driving power line, a common power line, and the like, which are arranged in the display area DA.

The fanout line 210 may include a first line 213i connected to the signal lines in the display area DA, a third line 213o connected to the terminal portion 20 in the peripheral area PA, and a second line 215 connecting the first line 213i to the third line 213o.

At least some of the fanout lines 210 may be arranged in the bending area BA. For example, the second line 215 of the fanout line 210 may overlap and be formed in the bending area BA. In some embodiments, the fanout line 210 may be arranged to extend from the first area 1A to the second area 2A across the bending area BA. That is, the fanout line 210 may extend across the bending axis BAX. Various modifications may be made to the fanout line 210; for example, the fanout line 210 may obliquely extend at a certain angle with respect to the bending axis BAX. In addition, the fanout line 210 may have various shapes, such as a curved shape or a zigzag shape. instead of a straight line. The fanout line 210 may be connected to a driving terminal 21 of the terminal portion 20 and configured to transmit an electrical signal to the display area DA.

The first line 213i of the fanout line 210 may be arranged in the first area 1A to be located on a layer different from a layer on which the second line 215 is located, and the first line 213i may be connected to the second line 215 through a contact hole. The contact hole may be arranged between the display area DA and the bending area BA. The first line 213i is connected to signal lines that are electrically connected to TFTs or other components in the display area DA, and thus, the fanout line 210 may be electrically connected to the TFTs or other components in the display area DA.

An organic material layer 160 may be arranged around the bending area BA, and in the bending area BA, the organic material layer 160 may be arranged under the second line 215.

As such, the fanout line 210 including the first line 213i, the second line 215, and the third line 213o may be designed by considering tensile stress and the like that are generated in the bending area BA.

The touch line 720 may be connected to the touch electrode 710 of the input detection layer 700 in the display area DA and extend from the upper portion of the encapsulation layer 300 so that at least a portion of the touch line 720 may be arranged in the bending area BA. In some embodiments, the touch line 720 may extend from the first area 1A to the second area 2A across the bending area BA. In other words, the touch line 720 may extend across the bending axis BAX. Various modifications may be made to the touch line 720; for example, the touch line 720 may obliquely extend at a certain angle with respect to the bending axis BAX. In addition, the touch line 720 may have various shapes, such as a curved shape or a zigzag shape, instead of a straight line shape. The touch line 720 may be connected to a touch terminal of the terminal portion 20 and exchange an electrical signal with the input detection layer 700.

Unlike the fanout line 210, the touch line 720 may extend from the display area DA as a single continuous line and may be connected to the terminal portion 20 across the bending area BA. In other words, because the touch line 720 is not formed by interconnecting lines on different layers, the touch line 720 may not include a contact hole between the display area DA and the bending area BA.

In the present embodiment, as the touch line 720 is used as a single continuous line ranging from the display area DA to the terminal portion 20, the area for contact holes becomes unnecessary. Accordingly, the area of the peripheral area PA may decrease.

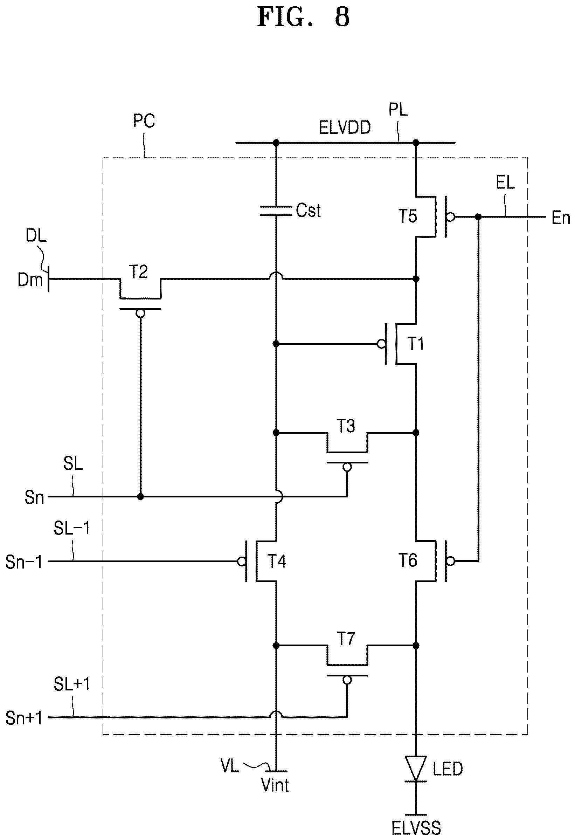

FIG. 8 is a schematic circuit diagram of a sub-pixel circuit of a sub-pixel arranged in a display area shown in FIG. 7.

Referring to FIG. 8, a plurality of sub-pixels may be arranged apart from each other in the display area DA (see FIG. 7). In this case, the sub-pixels may include a first sub-pixel, a second sub-pixel, and a third sub-pixel which emit light of the same color or different colors. For example, the first sub-pixel, the second sub-pixel, and the third sub-pixel may emit white light. In another embodiment, the first sub-pixel may emit red light, the second sub-pixel may emit green light, and the third sub-pixel may emit blue light. In another embodiment, the first sub-pixel may emit red light, the second sub-pixel may emit yellow light, and the third sub-pixel may emit blue light.

The sub-pixel may include a light-emitting diode LED and a sub-pixel circuit PC controlling the operation of the light-emitting diode LED. The light-emitting diode LED may be electrically connected to the sub-pixel circuit PC. In this case, the light-emitting diode LED may be an OLED.

The sub-pixel circuit PC may include a first TFT T1, a second TFT T2, a third TFT T3, a fourth TFT T4, a fifth TFT T5, a sixth TFT T6, a seventh TFT T7, and a storage capacitor Cst.

The second TFT T2 may be a switching TFT, connected to a scan line SL and a data line DL, and configured to transmit, to the first TFT T1, a data voltage (or a data signal Dm) that is input through the data line DL, according to a switching voltage (or a switching signal, that is a scan signal Sn) that is input through the scan line SL. The storage capacitor Cst may be connected to the first TFT T1 and the driving voltage line PL and store a voltage corresponding to a difference between a voltage, which is transmitted from the second TFT T2, and the first power voltage ELVDD provided to the driving voltage line PL.

The first TFT T1 is a driving TFT and may be connected to the driving voltage line PL and the storage capacitor Cst and configured to control a driving current flowing through the light-emitting diode LED from the driving voltage line PL, according to the voltage stored in the storage capacitor Cst. The light-emitting diode LED may emit light having a certain luminance because of the driving current. A second electrode (e.g., a cathode) of the light-emitting diode LED may be supplied with a second power voltage ELVSS.

The third TFT T3 may be a compensation TFT, and a gate electrode of the third TFT T3 may be connected to the scan line SL. A source electrode (or a drain electrode) of the third TFT T3 may be connected to a drain electrode (or source electrode) of the first TFT T1 and also to the first electrode of the light-emitting diode LED via the sixth TFT T6. A drain electrode (or a source electrode) of the third TFT T3 may be connected to any one electrode of the storage capacitor Cst, a source electrode (or a drain electrode) of the fourth TFT T4, and the gate electrode of the first TFT T1. The third TFT T3 is turned on in response to the scan signal Sn transmitted through the scan line SL and connects the gate electrode of the first TFT T1 to the drain electrode thereof, thereby diode-connecting the first TFT T1.

The fourth TFT T4 may be an initialization TFT, and a gate electrode of the fourth TFT T4 may be connected to a previous scan line SL-1. The drain electrode (or the source electrode) of the fourth TFT T4 may be connected to an initialization voltage line VL. The drain electrode (or the source electrode) of the fourth TFT T4 may be connected to any one electrode of the storage capacitor Cst, the drain electrode (or the source electrode) of the third TFT T3, and the gate electrode of the first TFT T1. The fourth TFT T4 may be turned on in response to a previous scan signal Sn-1 transmitted through the previous scan line SL-1 and configured to transmit an initialization voltage Vint to the gate electrode of the first TFT T1, thereby performing an initialization operation of initializing the voltage at the gate electrode of the first TFT T1.

The fifth TFT T5 may be an operation control TFT, and a gate electrode of the fifth TFT T5 may be connected to an emission control line EL. The drain electrode (or the source electrode) of the fifth TFT T5 may be connected to the driving voltage line PL. The drain electrode (or the source electrode) of the fifth TFT T5 is connected to the source electrode (or the drain electrode) of the first TFT T1 and the drain electrode (or the source electrode) of the second TFT T2.

The sixth TFT T6 may be an emission control TFT, and a gate electrode of the sixth TFT T6 may be connected to an emission control line EL. The source electrode (or the drain electrode) of the sixth TFT T6 may be connected to the drain electrode (or the source electrode) of the first TFT T1 and the source electrode (or the drain electrode) of the third TFT T3. The drain electrode

(or the source electrode) of the sixth TFT T6 may be electrically connected to the first electrode of the light-emitting diode LED. The fifth TFT T5 and the sixth TFT T6 are simultaneously turned on in response to the emission control signal En transmitted through the emission control line EL so that the first power voltage ELVDD may be transmitted to the light-emitting diode LED, and the driving current may flow through the light-emitting diode LED.

The seventh TFT T7 may be an initialization TFT configured to initialize the first electrode of the light-emitting diode LED. The gate electrode of the seventh TFT T7 may be connected to a next scan line SL+1. A source electrode (or a drain electrode) of the seventh TFT T7 may be connected to the first electrode of the light-emitting diode LED. The drain electrode (or the source electrode) of the seventh TFT T7 may be connected to the initialization voltage line VL. The seventh TFT T7 is turned on in response to a next scan signal Sn+1 transmitted through the next scan line SL+1 and thus initializes the first electrode of the light-emitting diode LED.

FIG. 8 illustrates that the fourth TFT T4 and the seventh TFT T7 are respectively connected to the previous scan line SL-1 and the next scan line SL+1, but in another embodiment, both the fourth TFT T4 and the seventh TFT T7 may be connected to the previous scan line SL-1 and operate according to the previous scan signal Sn-1.

Another electrode of the storage capacitor Cst may be connected to the driving voltage line PL. Any one electrode of the storage capacitor Cst may be connected to the gate electrode of the first TFT T1, the drain electrode (or the source electrode) of the third TFT T3, and the source electrode (or the drain electrode) of the fourth TFT T4.

The second electrode (e.g., the cathode) of the light-emitting diode LED may be supplied with the second power voltage ELVSS. The light-emitting diode LED receives the driving current from the first TFT T1 and emits light.

The light-emitting diode LED, which is the display element, may be an OLED including an organic material as a light-emitting material. In another embodiment, the light-emitting diode may be an inorganic light-emitting diode including an inorganic material. The inorganic light-emitting diode may include a PN junction diode including materials based on an inorganic semiconductor. When a voltage is applied to the PN junction diode in a forward direction, electrons and holes may be injected, and the energy generated from the recombination of the electrons and holes may be converted into light energy so that light of a certain color may be emitted. The inorganic light-emitting diode described above may have a width ranging from several to several hundred micrometers or from several to several hundred nanometers. In some embodiments, the light-emitting diode LED may include a quantum dot light-emitting diode. As described above, an emission layer of the light-emitting diode LED may include organic materials, inorganic materials, quantum dots, both organic materials and quantum dots, or both inorganic materials and quantum dots. Hereinafter, for convenience of explanation, it is described that the light-emitting diode LED includes an OLED.

FIG. 8 illustrates that the sub-pixel circuit PC includes seven TFTs and one capacitor, but example embodiments are not limited thereto. For example, in another embodiment, the sub-pixel circuit PC may include two or more TFTs and two or more capacitors. In addition, the circuit design of the sub-pixel circuit PC is not limited to that shown in FIG. 8 and may vary.

The first TFT T1 to the seventh TFT T7 may be TFTs of various types. In an embodiment, as shown in FIG. 5, each of the first TFT T1 to the seventh TFT T7 may be a P-channel MOSFET (PMOS). In another embodiment, at least one of the first TFT T1 to the seventh TFT T7 may be a PMOS, while the others may each be an N-channel MOSFET (NMOS). In another embodiment, the first TFT T1 to the seventh TFT T7 may each be an NMOS. The positions of the sources and the drains may vary depending on the type of the TFT (P-type or N-type).

The first TFT T1 to the seventh TFT T7 shown in FIG. 8 may each be a TFT including a low-temperature polycrystalline silicon (LTPS) semiconductor layer. In this case, the first TFT T1 to the seventh TFT T7 are not limited to those described above. At least one of the first TFT T1 to the seventh TFT T7 may be a TFT including an LTPS semiconductor layer, while the others may each be a TFT including an oxide semiconductor layer. Alternatively, the first TFT T1 to the seventh TFT T7 may each be a TFT including an oxide semiconductor layer.

FIG. 9 is a cross-sectional view of the display panel, taken along a line A-A' of FIG. 7.

Referring to FIG. 9, the display panel 10 may include a sub-pixel circuit PC arranged on (e.g., formed on) the substrate 100 and an organic light-emitting diode OLED electrically connected to the sub-pixel circuit PC. The sub-pixel circuit PC may include the first TFT T1 and the storage capacitor Cst.

The substrate 100 may include various materials, such as a metal material or a plastic material. In an embodiment, the substrate 100 may be a flexible substrate. The substrate 100 may include a first substrate base layer, a first barrier layer, a second substrate base layer, and a second barrier layer which are sequentially stacked. The first substrate base layer and the second substrate base layer may each include polymer resin. For example, the first substrate base layer and the second substrate base layer may each include polymer resin, such as polyethersulfone (PES), polyacrylate (PAR), polyetherimide (PEI), polyethylene naphthalate (PEN), polyethylene terepthalate (PET), polyphenylene sulfide (PPS), polyimide (PI), polycarbonate (PC), or cellulose acetate propionate (CAP). The polymer resin may be clear. Each of the first barrier layer and the second barrier layer may be a layer that limits and/or prevents the penetration of external foreign materials and may be a layer or layers including an inorganic material, such as amorphous silicon, silicon nitride, and/or silicon oxide.

A buffer layer 110 may be arranged on (e.g., formed on) the substrate 100. The buffer layer 110 may limit and/or prevent foreign materials or moisture from penetrating through the substrate 100. The buffer layer 110 may include an inorganic material, such as silicon oxide, silicon nitride, and/or silicon oxynitride and may be a layer or layers.

The first TFT T1 may be one of the TFTs described above with reference to FIG. 8 and may be, for example, the first TFT T1 (see FIG. 8) that is the driving TFT. The first TFT T1 may include a semiconductor layer ACT, a gate electrode GE, a source area SE, and a drain area DE.

The semiconductor layer ACT may include amorphous silicon, polycrystalline silicon, an oxide semiconductor material, or an organic semiconductor material. The semiconductor layer ACT may include a channel area CH overlapping the gate electrode GE and a source area SE and a drain area DE that are arranged on (e.g., formed on) both sides of the channel area CH and include impurities. Here, the impurities may include N-type impurities or P-type impurities. The source area SE and the drain area DE may be a source electrode and a drain electrode of the first TFT T1, respectively.

The gate electrode GE may be a layer or layers including one or more conductive materials, for example, one or more materials selected from aluminum (Al), platinum (Pt), palladium (Pd), silver (Ag), magnesium (Mg), gold (Au), nickel (Ni), neodymium (Nd), iridium (Ir), chromium (Cr), lithium (Li), calcium (Ca), molybdenum (Mo), titanium (Ti), tungsten (W), and/or copper (Cu) by considering adhesion to adjacent layers, surface flatness of stacked layers, and processibility. A first gate insulating layer 111 may be arranged between (e.g., formed between) the semiconductor layer ACT and the gate electrode GE.

The storage capacitor Cst may include a lower electrode CE1 and an upper electrode CE2 that overlap each other with a second gate insulating layer 112 therebetween. The storage capacitor Cst may overlap the first TFT T1. FIG. 9 illustrates that the gate electrode GE of the first TFT T1 is the lower electrode CE1 of the storage capacitor Cst. In another embodiment, the storage capacitor Cst may not overlap the first TFT T1.

The first gate insulating layer 111 and the second gate insulating layer 112 may include an inorganic insulating material, such as silicon oxide, silicon nitride, silicon oxynitride, aluminum oxide, titanium oxide, tantalum oxide, or hafnium oxide. The first gate insulating layer 111 and the second gate insulating layer 112 may each be a layer or layers including the above material.

The storage capacitor Cst may be covered by an interlayer insulating layer 113. The interlayer insulating layer 113 may include an inorganic insulating material, such as silicon oxide, silicon nitride, silicon oxynitride, aluminum oxide, titanium oxide, tantalum oxide, and/or hafnium oxide. The interlayer insulating layer 113 may be a layer or layers including the above material.

The driving voltage line PL and the first connection electrode CM1 may be arranged on (e.g., formed on) the interlayer insulating layer 113. Each of the driving voltage line PL and the first connection electrode CM1 may be a layer or layers including one or more materials selected from Al, Pt, Pd, Ag, Mg, Au, Ni, Nd, Ir, Cr, Li, Ca, Mo, Ti, W, and/or Cu. In an embodiment, each of the driving voltage line PL and the first connection electrode CM1 may be layers including Ti/Al/Ti.

A first insulating layer 115 may be arranged on (e.g., formed on) the driving voltage line PL and the first connection electrode CM1. The data line DL and a second connection electrode CM2 may be arranged on (e.g., formed on) the first insulating layer 115. The data line DL and the second connection electrode CM2 may include the same material as the driving voltage line PL. For example, each of the data line DL and the second connection electrode CM2 may be a layer or layers including one or more materials selected from Al, Pt, Pd, Ag, Mg, Au, Ni, Nd, Ir, Cr, Li, Ca, Mo, Ti, W, and/or Cu. In an embodiment, each of the data line DL and the second connection electrode CM2 may be layers including Ti/Al/Ti. The data line DL and the second connection electrode CM2 may be covered by a second insulating layer 116. As shown in FIG. 9, at least a portion of the data line DL may overlap the driving voltage line PL. In another embodiment, the data line DL may not overlap the driving voltage line PL.

FIG. 9 illustrates that the data line DL is arranged on (e.g., formed on) an upper layer of the driving voltage line PL, but in another embodiment, the data line DL may be arranged on (e.g., formed on) the interlayer insulating layer 113 or the driving voltage line PL may be arranged on (e.g., formed on) the first insulating layer 115 such that the data line DL and the driving voltage line PL may be arranged on (e.g., formed on) the same layer. In another embodiment, the driving voltage line PL may have a two-layer structure that includes a lower driving voltage line arranged on (e.g., formed on) the interlayer insulating layer 113 and an upper driving voltage line arranged on (e.g., formed on) the first insulating layer 115 and electrically connected to the lower driving voltage line.

The first insulating layer 115 and the second insulating layer 116 may each be a planarization insulating layer that may be an organic insulating layer. For example, each of the first insulating layer 115 and the second insulating layer 116 may include an organic insulating material, for example, a general-purpose polymer such as polymethylmethacrylate (PMMA) or polystyrene (PS), a polymer derivative having a phenol-based group, an acryl-based polymer, an imide-based polymer, a siloxane-based polymer, an aryl-ether-based polymer, an amide-based polymer, a fluorine-based polymer, a p-xylene-based polymer, and/or a vinyl-alcohol-based polymer, and any blend thereof. In an embodiment, the first insulating layer 115 and/or the second insulating layer 116 may be an organic insulating layer including PI or siloxane.

A plurality of display elements may be arranged apart from each other in the display area DA above the second insulating layer 116. For example, a plurality of organic light-emitting diodes OLED that are display elements of the sub-pixels may be arranged. In this case, the organic light-emitting diodes OLED may be arranged apart from each other in the display area DA and include a first organic light-emitting diode, a second organic light-emitting diode, and a third organic light-emitting diode which emit light of different colors or the same color. Each organic light-emitting diode OLED may include a pixel electrode 221, an intermediate layer 222, and an opposite electrode 223. Hereinafter, for convenience of explanation, a case where the first organic light-emitting diode, the second organic light-emitting diode, and the third organic light-emitting diode emit light of different colors is mainly described in detail.

The pixel electrode 221 of the organic light-emitting diode OLED may be arranged on (e.g., formed on) the second insulating layer 116 and may be connected to the first TFT T1 through the first connection electrode CM1 on the interlayer insulating layer 113 and the second connection electrode CM2 on the first insulating layer 115.

The pixel electrode 221 may include conductive oxide, such as indium tin oxide (ITO), indium zinc oxide (IZO), zinc oxide (ZnO), indium oxide (In₂O₃), indium gallium oxide (IGO), and/or aluminum zinc oxide (AZO). In an embodiment, the pixel electrode 221 may include a reflection film including Ag, Mg, Al, Pt, Pd, Au, Ni, Nd, Ir, Cr, and/or a compound thereof. In another embodiment, the pixel electrode 221 may further include a film including ITO, IZO, ZnO, or In₂O₃ on/under the above reflection film.

A third insulating layer 118 may be arranged on (e.g., formed on) the second insulating layer 116. The third insulating layer 118 may include an opening corresponding to each pixel in the display area DA, that is, an opening exposing a portion of the pixel electrode 221. The third insulating layer 118 may be a pixel-defining layer, and an opening 118op of the third insulating layer 118 may define an emission area of a pixel. The emission area may be an area where an emission layer is arranged and light is emitted. In other words, the third insulating layer 118 may be arranged to correspond to areas other than the emission area, that is, non-emission areas. The size of the emission area may differ according to the color of light emitted from the pixel.

In addition, the third insulating layer 118 may increase a distance between the edge of the pixel electrode 221 and the opposite electrode 223 arranged on (e.g., formed on) the pixel electrode 221 and thus may limit and/or prevent arcs, etc. from being generated on the edge of the pixel electrode 221. The third insulating layer 118 may include an organic material, such as PI and/or hexamethyldisiloxane (HMDSO).

The intermediate layer 222 includes an emission layer. The emission layer may include a high-molecular-weight organic material or a low-molecular-weight organic material emitting light of a certain color. In an embodiment, the intermediate layer 222 may include a first functional layer arranged under the emission layer and/or a second functional layer arranged on (e.g., formed on) the emission layer. The first functional layer and/or the second functional layer may include a layer integrally formed as a single body over the pixel electrodes 221 and a layer patterned to correspond to each of the pixel electrodes 221. In the above case, the emission layer may be arranged to correspond to each organic light-emitting diode OLED. In this case, the emission layers respectively arranged on (e.g., formed on) the first organic light-emitting diode, the second organic light-emitting diode, and the third organic light-emitting diode may include different materials. In another embodiment, a single emission layer may be arranged to cover the first organic light-emitting diode, the second organic light-emitting diode, and the third organic light-emitting diode. In this case, the emission layer arranged on (e.g., formed on) the first organic light-emitting diode, the second organic light-emitting diode, and the third organic light-emitting diode may include the same material and may be arranged in the entire display area DA. In this case, the emission layer may also have a structure in which different emission layers are stacked.

The first functional layer may be a layer or layers. For example, when the first functional layer includes a high-molecular-weight material, the first functional layer may be a Hole Transport Layer (HTL) having a single-layer structure and include poly-(3,4)-ethylene-dihydroxy thiophene (PEDOT) and/or polyaniline (PANI). When the first functional layer includes a low-molecular-weight material, the first functional layer may include a Hole Injection Layer (HIL) and an HTL.

The second functional layer may be optional or not necessarily included. For example, when the first functional layer and the emission layer each include a high-molecular-weight material, the second functional layer may be formed to enhance the characteristics of the organic light-emitting diodes. The second functional layer may be a layer or layers. The second functional layer may include an Electron Transport Layer (ETL) and/or an Electron Injection Layer (EIL).

The opposite electrode 223 may face the pixel electrode 221 with the intermediate layer 222 therebetween. The opposite electrode 223 may include a conductive material having a low work function. For example, the opposite electrode 223 may include a transparent (or translucent) layer including Ag, Mg, Al, Pt, Pd, Au, Ni, Nd, Ir, Cr, Li, Ca, and/or an alloy thereof. Alternatively, the opposite electrode 223 may further include a layer including ITO, IZO, ZnO, or In₂O₃ on the transparent (or translucent) layer including the above material.

The opposite electrode 223 may be integrally formed as a single body over the organic light-emitting diodes OLED in the display area DA and face the pixel electrodes 221 such that the opposite electrode 223 may be arranged on (e.g., formed on) the intermediate layer 222 and the third insulating layer 118.

A plurality of spacers 119 may be further arranged in the non-emission area of the display area DA. The spacers 119 may be arranged around the pixel electrodes 221, that is, between the pixel electrodes 221. The spacer 119 may be arranged on (e.g., formed on) the third insulating layer 118. The spacer 119 may be an insulating pattern having an island shape. The spacer 119 may have various shapes, such as a square, a circle, a triangle, or an oval. The spacer 119 may include an organic insulating material, such as PI. Alternatively, the spacer 119 may include an inorganic insulating material, such as silicon nitride or silicon oxide, or both an organic insulating material and an inorganic insulating material. The spacer 119 may include a material different from that of the third insulating layer 118. Alternatively, the spacer 119 may include the same material as one of the first insulating layer 115, the second insulating layer 116, and the third insulating layer 118. The opposite electrode 223 may be arranged on (e.g., formed on) the spacer 119.

The encapsulation layer 300 may be arranged on (e.g., formed on) the opposite electrode 223 such that the display panel 10 may be protected from external foreign materials or moisture. The encapsulation layer 300 may include at least one organic encapsulation layer and at least one inorganic encapsulation layer. FIG. 9 illustrates that the encapsulation layer 300 includes a first inorganic encapsulation layer 310, a second inorganic encapsulation layer 330, and an organic encapsulation layer 320 therebetween. In another embodiment, the number of organic encapsulation layers and the number of inorganic encapsulation layers and stacking orders thereof may vary.

A plurality of layers including capping layers 230 may be arranged between the first inorganic encapsulation layer 310 and the opposite electrode 223. FIG. 9 illustrates the capping layer 230, but in another embodiment, the capping layer 230 may be omitted.

The first inorganic encapsulation layer 310 and the second inorganic encapsulation layer 330 may each include one or more inorganic insulating materials from among aluminum oxide, titanium oxide, tantalum oxide, hafnium oxide, zinc oxide, silicon oxide, silicon nitride, and/or silicon oxynitride. The organic encapsulation layer 320 may include PET, PEN, PC, PI, polyethylene sulfonate, polyoxymethylene, PAR, HMDSO, and/or acrylic resin (e.g., PMMA, polyacrylic acid, etc.), or an arbitrary combination thereof. Because the first inorganic encapsulation layer 310 is formed along the structure thereunder, the upper surface of the first inorganic encapsulation layer 310 may be uneven. The organic encapsulation layer 320 may have a sufficient thickness and cover the first inorganic encapsulation layer 310. The upper surface of the organic encapsulation layer 320 may be substantially flat. The second inorganic encapsulation layer 330 may extend to the outer side of the organic encapsulation layer 320 and contact the first inorganic encapsulation layer 310 such that the external exposure of the organic encapsulation layer 320 may be prevented.

Next, the peripheral area PA is described. The peripheral area PA of FIG. 9 may correspond to a portion of the lower side of the display area DA of FIG. 7. In the peripheral area PA, the first insulating layer 115, the second insulating layer 116, and the third insulating layer 118 may extend from the display area DA. At least one dam portion DAM may be arranged in a dam area located within the peripheral area PA. FIG. 9 illustrates two dam portions DAM.

The dam portions DAM may include a first dam DAM1 and a second dam DAM2. In this case, the first dam DAM1 and the second dam DAM2 may be arranged on (e.g., formed on) an inorganic layer. For example, the first dam DAM1 and the second dam DAM2 may be arranged on (e.g., formed on) an inorganic insulating layer that includes at least one of the buffer layer 110, the first gate insulating layer 111, the second gate insulating layer 112, and the interlayer insulating layer 113.

The first dam DAM1 may be arranged in the peripheral area PA, and the second dam DAM2 may be arranged between the first dam DAM1 and the display area DA and relatively closer to the display area DA than the first dam DAM1.

Each dam portion DAM may have a multilayered structure including a plurality of layers. To allow the dam portion DAM to limit the location of a material for forming an organic encapsulation layer, it may be advantageous to form the first dam DAM1, which is on the outermost side, to have a relatively greater height than the second dam DAM2. The dam portion DAM may include a greater number of layers so that the height of the first dam DAM1, which is located on the outermost side from the display area DA, is greater than that of the second dam DAM2. For example, the second dam DAM2 may include two layers: a first layer 116D, which is the lowermost layer, and a second layer 118D on the first layer 116D which are stacked in a direction away from the upper surface of the substrate 100, that is, the z direction. The first dam DAM1 may include three layers stacked in the z direction: a first layer 116D that is the lowermost layer; a second layer 118D on the first layer 116D; and a third layer 119D on the second layer 118D.

Each dam portion DAM may include a plurality of organic insulating layers. For example, the first layer 116D may be simultaneously formed of the same material as the second insulating layer 116 when the second insulating layer 116 is formed in the display area DA. The second layer 118D may be simultaneously formed of the same material as the third insulating layer 118 when the third insulating layer 118 is formed in the display area DA. The third layer 119D may be simultaneously formed of the same material as the spacer 119 when the spacer 119 is formed in the display area DA.

Referring to FIG. 9, the driving voltage supply line 30 may be arranged in the peripheral area PA located under the display area DA, as shown in FIG. 7. The driving voltage supply line 30 may be arranged in the peripheral area PA. A portion of the driving voltage supply line 30 may be arranged between the first insulating layer 115 and the second insulating layer 116 within the peripheral area PA, and another portion of the driving voltage supply line 30 may be arranged on (e.g., formed on) the interlayer insulating layer 113 within the peripheral area PA.

A plurality of holes may be defined in the driving voltage supply line 30 located in the peripheral area PA. The holes may function as outgassing paths through which gas generated from the first insulating layer 115 is discharged outside, thereby preventing or reducing the degradation in image quality on a display panel caused by the penetration of gas or moisture from the first insulating layer 115 into the display area DA. The driving voltage supply line 30 may include the same material as one of the lines arranged between the first insulating layer 115 and the second insulating layer 116 in the display area DA. For example, the driving voltage supply line 30 may include the same material as the data line DL arranged on (e.g., formed on) the first insulating layer 115 within the display area DA.

At least one line overlapping the driving voltage supply line 30 may be arranged between the interlayer insulating layer 113 and the first insulating layer 115 arranged in the peripheral area PA. The at least one line may include the same material as one of the lines arranged between the interlayer insulating layer 113 and the first insulating layer 115 within the display area DA. For example, the at least one line may include the same material as the driving voltage line PL arranged on (e.g., formed on) the interlayer insulating layer 113 within the display area DA.

In the peripheral area PA on the lower side of the display area DA (see FIG. 7), a plurality of fanout lines 210 may be arranged. In an embodiment, as shown in FIG. 9, the fanout lines 210 may be arranged on (e.g., formed on) different layers with at least one insulating layer therebetween. For example, a first fanout line 210a on the first gate insulating layer 111 and second fanout lines 210b on the second gate insulating layer 112 may be alternately arranged. Accordingly, the gap between adjacent fanout lines 210 may be reduced. In another embodiment, the fanout lines 210 may be arranged on (e.g., formed on) the same layer. For example, the fanout lines 210 may be arranged on (e.g., formed on) the first gate insulating layer 111 or the second gate insulating layer 112.

A first scan driving circuit and a second scan driving circuit may be arranged in the peripheral area PA.

The first inorganic encapsulation layer 310 and the second inorganic encapsulation layer 330 may cover the first dam DAM1 and the second dam DAM2 and may be formed to the outer sides of the first dam DAM1 and the second dam DAM2. The organic encapsulation layer 320 may be confined by the first dam DAM1 and the second dam DAM2, which limited and/or prevents the material for forming the organic encapsulation layer 320 from overflowing beyond the outer sides of the first dam DAM1 and the second dam DAM2.

The input detection layer 700 may be arranged on (e.g., formed on) the encapsulation layer 300 described above. The input detection layer 700 may include a touch buffer layer 750, a touch electrode 710 including a first touch conductive layer 711 and a second touch conductive layer 713, a first touch insulating layer 730, a second touch conductive layer 713, a second touch insulating layer 740, and a touch line 720, all of which are sequentially arranged on (e.g., formed on) the encapsulation layer 300. In another embodiment, the input detection layer 700 may include the first touch conductive layer 711, the first touch insulating layer 730, the second touch conductive layer 713, the second touch insulating layer 740, and the touch line 720, which are sequentially arranged on (e.g., formed on) the encapsulation layer 300.

In some embodiments, the first touch conductive layer 711 and the second touch conductive layer 713 may function as touch electrodes that sense contact, and the first touch conductive layer 711 may function as a connecting portion that connects in one direction the second touch conductive layer 713 that is patterned.

In some embodiments, the first touch conductive layer 711 and the second touch conductive layer 713 may both function as touch electrodes. For example, the first touch insulating layer 730 may include a via hole exposing the upper surface of the first touch conductive layer 711, and the first touch conductive layer 711 may be connected to the second touch conductive layer 713 through the via hole. As described, as the first touch conductive layer 711 and the second touch conductive layer 713 are used, resistance in the touch electrodes is reduced such that the response speed of the input detection layer 700 may increase.

In some embodiments, the touch electrode 710 may have a mesh structure to allow the light emitted from the organic light-emitting diode OLED to pass through. Accordingly, the first touch conductive layer 711 and the second touch conductive layer 713 may be arranged not to overlap the emission area of the organic light-emitting diode OLED.

The first touch conductive layer 711 and the second touch conductive layer 713 may each be a layer or layers including a conductive material that may have great conductivity. For example, the first touch conductive layer 711 and the second touch conductive layer 713 may each be a layer or layers including a transparent conductive layer or a conductive material including Al, Cu, Mo, and/or Ti. The transparent conductive layer may include transparent conductive oxide, such as ITO, IZO, ZnO, or ITZO. Alternatively, the transparent conductive layer may include a conductive polymer such as PEDOT, metal nanowire, graphene, or the like. In some embodiments, the first touch conductive layer 711 may include Mo, while the second touch conductive layer 713 may have a stack structure including Ti/Al/Ti.

The first touch conductive layer 711 or the second touch conductive layer 713 may be connected to the touch line 720 passing through the peripheral area PA. In this case, the touch line 720 may be connected to the terminal portion 20 shown in FIG. 7.

The first touch insulating layer 730 and the second touch insulating layer 740 may each include an inorganic material or an organic material. The inorganic material may be at least any one of silicon nitride, aluminum nitride, zirconium nitride, titanium nitride, hafnium nitride, tantalum nitride, silicon oxide, aluminum oxide, titanium oxide, tin oxide, cerium oxide, or silicon oxynitride. The organic material may be at least any one of acrylic resin, methacrylic resin, polyisoprene, vinyl-based resin, epoxy-based resin, urethane-based resin, cellulose-based resin, and perylene-based resin.

In an embodiment, the first touch insulating layer 730 and/or the second touch insulating layer 740 may be arranged in the entire display area DA.

The second touch insulating layer 740 may be formed to completely block the second touch conductive layer 713.

In such a case, the taper angle formed by the side surface and the lower surface of at least one layer simultaneously formed in the display area DA and the peripheral area PA may differ between the display area DA and the peripheral area PA. For example, the taper angle of at least one layer arranged in the display area DA may be greater than that of at least one layer simultaneously formed and arranged in the peripheral area PA. That is, the taper angle of at least one layer simultaneously formed and arranged in the peripheral area PA may be less than that of at least one layer arranged in the display area DA. In this case, the taper angle may refer to the angle formed by the lower surface and the side surface of each layer.

In detail, the angle formed by the side surface and the lower surface of each of the gate electrode GE, the lower electrode CE1, and the upper electrode CE2 that are formed through the same process as the fanout line 210 may be different from the angle formed by the side surface and the lower surface of the fanout line 210. In detail, a first taper angle θ1 formed by the side surface and the lower surface of the first fanout line 210a may be less than a second taper angle θ2 formed by the side surface and the lower surface of one of the lower electrode CE1 and the gate electrode GE. In addition, a third taper angle θ3 formed by the side surface and the lower surface of the second fanout line 210b may be less than a fourth taper angle θ4 formed by the side surface and the lower surface of the upper electrode CE2. A fifth taper angle θ5 formed by the side surface and the lower surface of a portion, on which the surfaces of the first gate insulating layer 111 and the second gate insulating layer 112 in the peripheral area PA are curved, or an end portion of the driving voltage supply line 30 may be less than a sixth taper angle θ6 formed by side surface and the lower surface of a portion, on which the surfaces of the first gate insulating layer 111 and the second gate insulating layer 112 in the display area DA are curved, or an end portion of the data line DL or the second connection electrode CM2.

Moreover, the taper angle of at least one organic insulating layer of the dam portion DAM arranged in the peripheral area PA may be less than the taper angle of at least one organic insulating layer arranged in the display area DA. For example, the first layer 116D of the first dam DAM1 and the first layer 116D of the second dam DAM2 may be formed together with the second insulating layer 116 in the display area DA and may also be formed when the contact hole CNT is formed, the contact hole CNT connecting the pixel electrode 221 on the second insulating layer 116 to the second connection electrode CM2. In this case, a seventh taper angle θ7 formed by the side surface and the lower surface of the first layer 116D may be less than an eighth taper angle θ8 of the contact hole CNT. The eighth taper angle θ8 may refer to the angle formed by the inner surface of the contact hole CNT and the upper surface of the second connection electrode CM2. In addition, the second layer 118D of the first dam DAM1 and the second layer 118D of the second dam DAM2 may be formed together with the third insulating layer 118 and also be formed when the opening 118op of the third insulating layer 118 is formed. In this case, a ninth taper angle θ9 formed by the side surface and the lower surface of the second layer 118D may be less than a tenth taper angle θ10 of the opening 118op. The tenth taper angle θ10 may refer to the angle formed by the inner surface of the opening 118op and the upper surface of the pixel electrode 221 or the angle formed by the inner surface of the opening 118op and the upper surface of the second insulating layer 116. The third layer 119D of the second dam DAM2 may be formed together with the spacer 119. An 11^{th} taper angle θ11 formed by the side surface and the lower surface of the third layer 119D may be less than a 12^{th} taper angle θ12 formed by the side surface and the lower surface of the spacer 119.

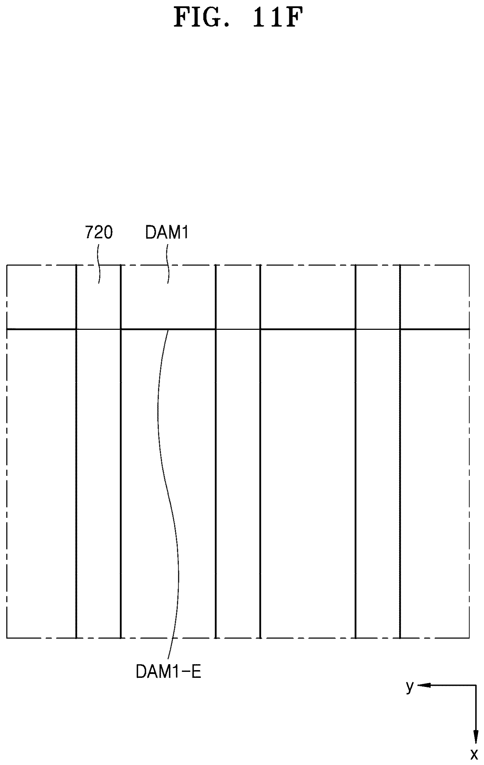

In the above case, the taper angles of respective layers stacked in the peripheral area PA may become gradually gentle (e.g., reduced) depending on heights. In this case, the touch lines 720 arranged on (e.g., formed on) the dam portion DAM may not interfere with each other. That is, referring to FIG. 11F described below, the touch lines 720 may be arranged apart from each other in one direction. In this case, when the touch lines 720 are formed, adjacent touch lines 720 may be connected to each other at the side surface or the boundary portion of the dam portion DAM so that noise may be generated in a touch signal or a touch signal may not be detected. However, as described above, the above problems may be overcome by forming the taper angle of at least one of the layers in the peripheral area PA to be less than that of at least one of the layers in the display area DA.

In addition, in the above case, it is possible to form a fine pattern in the display area DA by forming the taper angle of at least one of the layers in the display area DA to be greater than that of at least one of the layers in the peripheral area PA. Thus, the display panel 10 may accommodate fine display elements and sub-pixel circuits more densely in the same area. In other words, it is possible not only to reduce the areas of the display elements and the sub-pixel circuits arranged in the same area, but also to arrange display elements and sub-pixel circuits as many as possible in the same area. Hereinafter, a method of differently setting the taper angles of at least one layer in the peripheral area PA and at least one layer in the display area DA is described in detail.

FIGS. 10A to 10H are schematic cross-sectional views illustrating a manufacturing sequence for a portion of the display panel of FIG. 9.

Referring to FIG. 10A, the buffer layer 110, the semiconductor layer ACT, and the first gate insulating layer 111 may be arranged on (e.g., formed on) the substrate 100 in the display area DA. A first base layer BMT may be arranged on (e.g., formed on) the first gate insulating layer 111. The first base layer BMT may be entirely arranged in the display area DA. The buffer layer 110, the first gate insulating layer 111, and the first base layer BMT may be arranged in the peripheral area PA of the substrate 100. The first base layer BMT may be entirely arranged in the display area DA and the peripheral area PA. First photoresist PR1 may be arranged on (e.g., formed on) the entire surface of the first base layer BMT. In the above case, the first base layer BMT may include a conductive material such as metal.

Referring to FIG. 10B, the first photoresist PR1 may be exposed to light and then developed. In this case, only a portion of the first photoresist PR1 may remain on the first base layer BMT. For example, the first photoresist PR1 may include 1-1^{st} photoresist PR1-1 arranged in the display area DA and 1-2^{nd} photoresist PR1-2 arranged in the peripheral area PA.

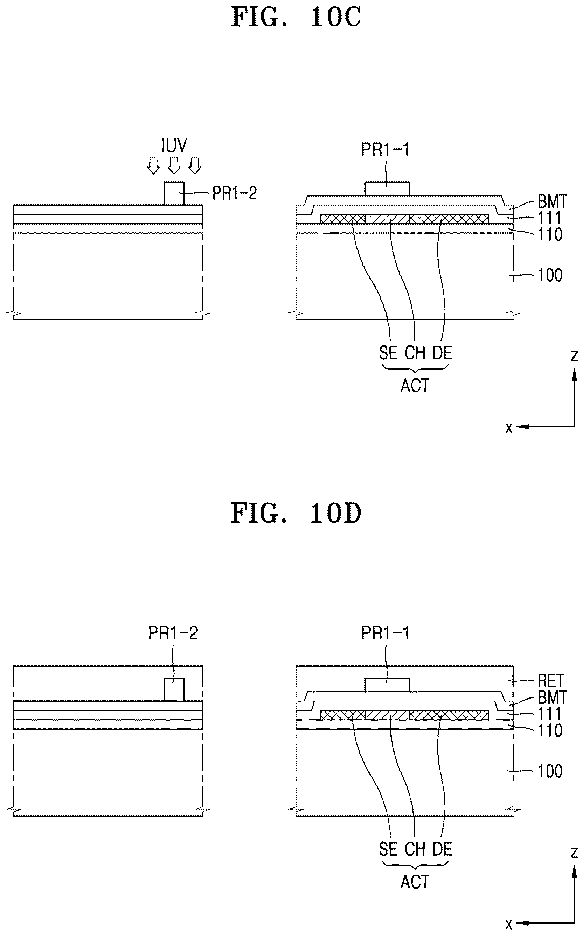

Referring to FIG. 10C, ultraviolet irradiation (UV irradiation) may be performed on the 1-2^{nd} photoresist PR1-2. In this case, ultraviolet light may be irradiated onto the 1-2^{nd} photoresist PR1-2 arranged only in the peripheral area PA. In addition, ultraviolet light may not be irradiated onto the 1-1^{st} photoresist PR1-1 arranged in the display area DA. Although not shown in the drawing, ultraviolet light may be irradiated onto both the display area DA and the peripheral area PA, and a separate mask for blocking the ultraviolet light may be arranged in the display area DA. In another embodiment, ultraviolet light may be irradiated onto only a certain region, for example, the peripheral area PA.

Referring to FIG. 10D, a shrinkage-inducing material RET may be applied on the 1-1^{st} photoresist PR1-1 arranged in the display area DA and the 1-2^{nd} photoresist PR1-2 arranged in the peripheral area PA. In this case, the shrinkage-inducing material RET may be entirely arranged in the display area DA and the peripheral area PA. The shrinkage-inducing material RET may include an acryl-based monomer (e.g., trimethylolpropane triacrylate (TMPTA)), a solvent, and a photoinitiator.

Referring to FIG. 10E, heat may be applied to the peripheral area PA where the shrinkage-inducing material RET is arranged. In this case, heat may also be applied to the shrinkage-inducing material RET arranged in the display area DA. In this case, the heat may be applied from the lower surface of the substrate 100 or the upper surface of the shrinkage-inducing material RET. In addition, the heat may be at a temperature in a range from about 90 °C to about 150 °C. The shrinkage-inducing material RET arranged in the display area DA may not react with the surface of the 1-1^{st} photoresist PR1-1 arranged in the display area DA. In contrast, the shrinkage-inducing material RET arranged in the peripheral area PA may react with the surface of the 1-2^{nd} photoresist PR1-2 arranged in the peripheral area PA.

Referring to FIG. 10F, the shrinkage-inducing material RET may be removed using ultrapure water DI after heat is applied. In this case, a portion of the shrinkage-inducing material RET arranged in the peripheral area PA may be coupled to the surface of the 1-2^{nd} photoresist PR1-2 arranged in the peripheral area PA. Then, heat may be applied to the 1-2^{nd} photoresist PR1-2. In this case, heat may be applied to both the display area DA and the peripheral area PA or only to the peripheral area PA. The heat may be in a range from about 150 °C to about 200 °C. In this case, the coupling between the shrinkage-inducing material RET in the peripheral area PA and the surface of the 1-2^{nd} photoresist PR1-2 may be strengthened, and a portion of the 1-2^{nd} photoresist PR1-2 may shrink. To this end, the inclination angle formed by the side surface and the lower surface of the 1-1^{st} photoresist PR1-1 arranged in the display area DA may be different from that formed by the side surface and the lower surface of the 1-2^{nd} photoresist PR1-2 arranged in the peripheral area PA. In other words, a first inclination angle θa formed by the side surface and the lower surface of the 1-1^{st} photoresist PR1-1 arranged in the display area DA may be greater than a second inclination angle θb formed by the side surface and the lower surface of the 1-2^{nd} photoresist PR1-2 arranged in the peripheral area PA.

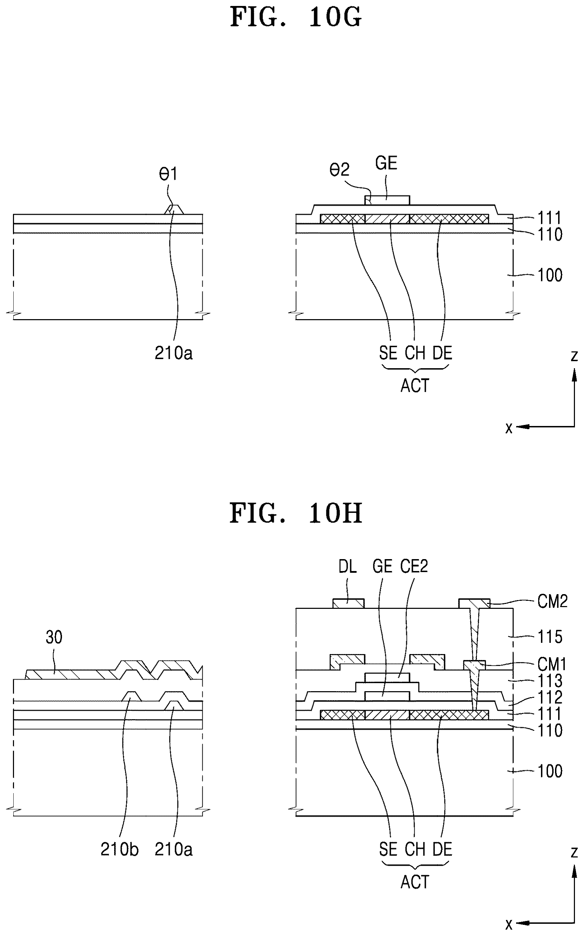

Referring to FIG. 10G, an etching solution may be sprayed or plasma may be irradiated onto the 1-1^{st} photoresist PR1-1 and the 1-2^{nd} photoresist PR1-2 formed as described above to remove a portion of the first base layer BMT, and accordingly, the gate electrode GE and/or the lower electrode CE1 may be formed on the first gate insulating layer 111 in the display area DA, and the first fanout line 210a may be formed in the peripheral area PA. In this case, the second taper angle θ2 of the gate electrode GE and/or the lower electrode CE1 may be different from the first taper angle θ1 of the first fanout line 210a.

Referring to FIG. 10H, the second gate insulating layer 112 may be arranged on (e.g., formed on) the first fanout line 210a, the gate electrode GE, and the lower electrode CE1, and then, the second fanout line 210b and the upper electrode CE2 may be arranged thereon. In addition, the interlayer insulating layer 113 may be arranged on (e.g., formed on) the second fanout line 210b and the upper electrode CE2. In this case, the second fanout line 210b and the upper electrode CE2 may be simultaneously formed and manufactured in a manner similar to the above-described manner used to form the first fanout line 210a and the lower electrode CE1 such that the taper angles may be different from each other.

Referring to FIGS. 10H and 9, the first connection electrode CM1 and the first insulating layer 115 may be arranged on (e.g., formed on) the interlayer insulating layer 113. In addition, the second connection electrode CM2, the data line DL, and the driving voltage supply line 30 may be arranged on (e.g., formed on) the first insulating layer 115. In this case, the taper angle of at least one of the data line DL and the second connection electrode CM2 may be different from that of the driving voltage supply line 30. In the case, a method of forming the driving voltage supply line 30 and at least one of the data line DL and the second connection electrode CM2 may be similar to a method of forming the first fanout line 210a and the lower electrode CE1.

Through the above process, at least one layer arranged in the display area DA and at least one layer arranged in the peripheral area PA may have different taper angles. To this end, disconnections of lines extending in the peripheral area PA in the longitudinal direction or interconnections between lines, which are spaced apart from each other, in the width direction may be reduced.

FIGS. 11A to 11E are schematic cross-sectional views illustrating a manufacturing sequence for a portion of the display panel of FIG. 9.

Referring to FIG. 11A, the seventh taper angle θ7 (see FIG. 9) of the first layer 116D of the dam portion DAM may be different from the eighth taper angle θ8 (see FIG. 9) of the contact hole CNT. In detail, the second base layer 116B may be arranged on (e.g., formed on) the first insulating layer 115, the second connection electrode CM2, the data line DL, and the driving voltage line PL to form the second insulating layer 116 and the first layer 116D. Then, the second photoresist PR2 may be arranged on (e.g., formed on) the second base layer 116B. In this case, the second photoresist PR2 may be arranged on (e.g., formed on) the entire second base layer 116B, and through exposure and development processes, 2-1^{st} photoresist PR2-1 and 2-2^{nd} photoresist PR2-2 that are spaced apart from each other may be formed. Then, as described above with reference to FIG. 10C, ultraviolet light may be irradiated onto the 2-2^{nd} photoresist PR2-2 arranged in the peripheral area PA.

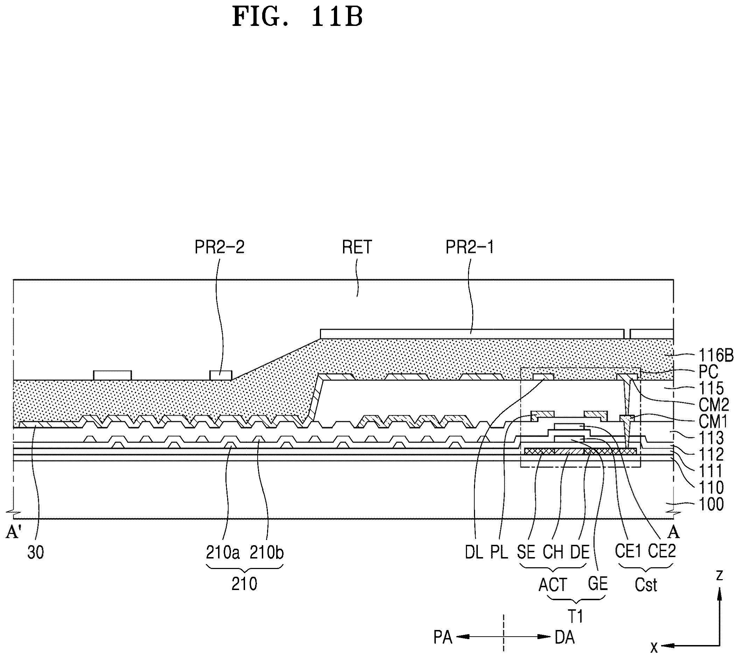

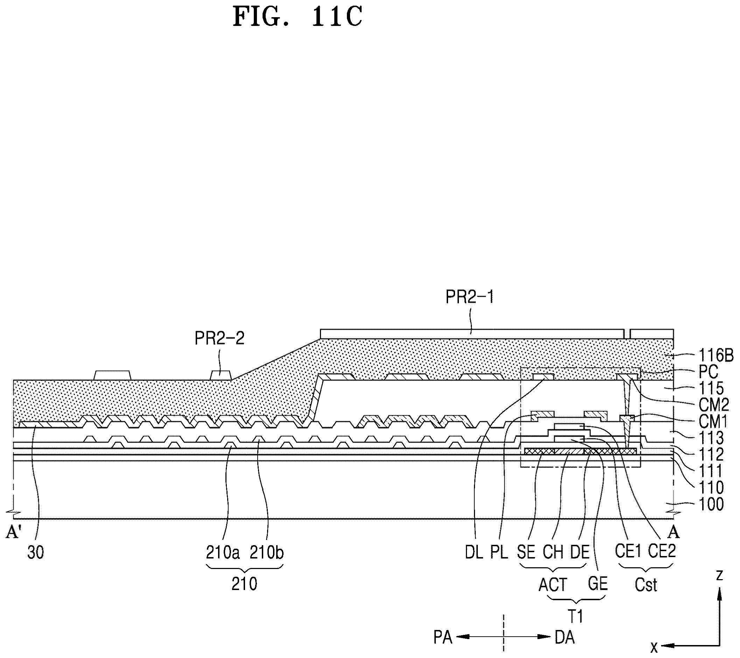

Referring to FIGS. 11B and 11C, after the shrinkage-inducing material RET is arranged on (e.g., formed on) the 2-2^{nd} photoresist PR2-2 and the 2-1^{st} photoresist PR2-1 onto which ultraviolet light is irradiated, the shrinkage-inducing material RET may be rinsed. When heat is applied to the second photoresist PR2, the shrinkage-inducing material RET arranged in the peripheral area PA may be coupled to the surface of the 2-2^{nd} photoresist PR2-2 as described above. Then, the surface of the 2-2^{nd} photoresist PR2-2 coupled to the shrinkage-inducing material RET may shrink when heat is applied to the 2-2^{nd} photoresist PR2-2. In this case, the inclination angle formed by the lower surface and the side surface of the 2-2^{nd} photoresist PR2-2 arranged in the peripheral area PA may be less than the inclination angle formed by the lower surface and the side surface of the 2-2^{nd} photoresist PR2-2 arranged in the display area DA.

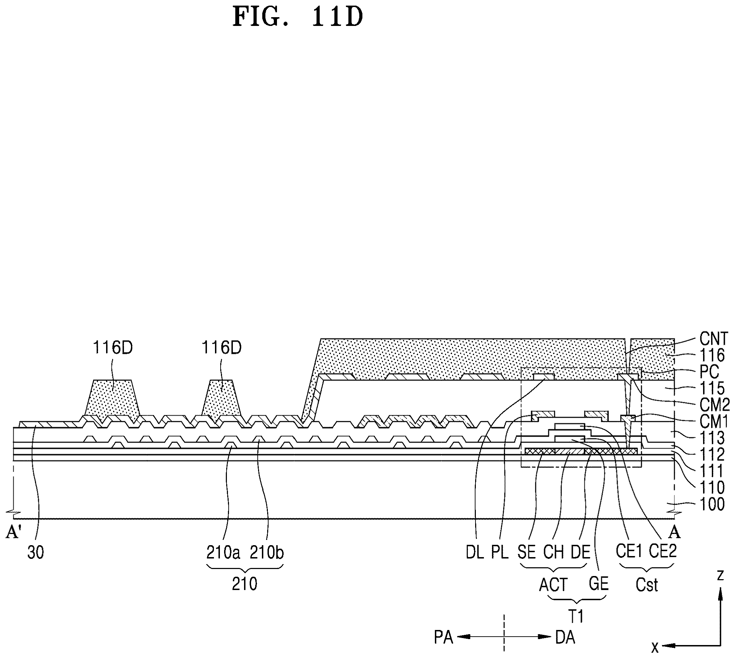

Referring to FIGS. 9 and 11D, the second base layer 116B may be etched using an etching solution, and thus, the contact hole CNT and the first layer 116D may be formed. Also, the second insulating layer 116 may be separated from the first layer 116D. In this case, the seventh taper angle θ7 of the first layer 116D may become different from the eighth taper angle θ8 of the contact hole CNT.

After the above process is completed, the pixel electrode 221, the third insulating layer 118, and the spacer 119 may be sequentially stacked on the second insulating layer 116. In addition, the second layer 118D and the third layer 119D may be arranged on (e.g., formed on) the first layer 116D. In this case, the formation of the second layer 118D and the third insulating layer 118 may be similar to that of the first layer 116D and the second insulating layer 116 described above. In this case, the tenth taper angle θ10 of the opening 118op of the third insulating layer 118 may be greater than the ninth taper angle θ9 of the second layer 118D. Also, the 11^{th} taper angle θ11 of the third layer 119D may be less than the 12^{th} taper angle θ12 of the spacer 119.

When the above process is completed, as shown in FIG. 9, the intermediate layer 222, the opposite electrode 223, the encapsulation layer 300, and the input detection layer 700 may be arranged on (e.g., formed on) the third insulating layer 118.

FIG. 11F is a schematic plan view of a portion of the display panel of FIG. 9.

Referring to FIG. 11F, the touch line 720 of the input detection layer 700 may extend towards an end portion of the substrate 100 from a portion of the display area DA or the peripheral area PA. In this case, the touch line 720 may extend along various curves in the peripheral area PA. Moreover, there may be a plurality of touch lines 720, and the touch lines 720 may be arranged apart from each other in the y direction of FIG. 11F.

In the above case, the touch lines 720, which are spaced apart from each other, may be formed by arranging a touch line base layer on the entire surface of a portion of the encapsulation layer 300 and then etching the touch line base layer. The touch line base layer may include the same material as the touch line 720. In this case, when the taper angle is overly great at the boundary of the dam portion, the touch lines 720, which are spaced apart from each other, may be connected. For example, FIG. 11F illustrates the touch lines 720 spaced apart from each other after the completion of etching. In this case, each of the touch lines 720 spaced apart from each other may be bent at an edge portion DAM1-E of the first dam DAM1. In this case, when the taper angle of the first dam DAM1 is the same as that of the contact hole CNT in the display area DA, the opening 118op of the third insulating layer 118, or the spacer 119, the thickness of the touch line base layer arranged at the edge portion DAM1-E of the first dam DAM1 may become greater than those of other portions of the touch line base layer. In this case, when the touch line base layer is etched, the touch line base layer arranged at the edge portion DAM1-E of the first dam DAM1 may not be completely etched. In this case, as the touch line base layer remains at the edge portion DAM1-E of the first dam DAM1, the touch lines 720 spaced apart from each other may be connected to each other in a direction different from the longitudinal direction of the touch line 720. When adjacent touch lines 720 are connected to each other, signals detected by the input detection layer 700 may not be accurately identified, or the signals may include noise. However, the above problems may be reduced by forming the taper angle of the first dam DAM1 to be gentler than the taper angle of a corresponding layer arranged in the display area DA. In addition, when the taper angle of the layer arranged in the display area DA is set to be the same as the taper angle of the layer arranged in the peripheral area PA, the number of sub-pixel circuits and the number of display elements arranged in the same area in the display area DA may decrease. However, as the layers respectively arranged in the display area DA and the peripheral area PA have different taper angles as described above, the number of sub-pixel circuits and the number of display elements arranged in the display area DA may increase.

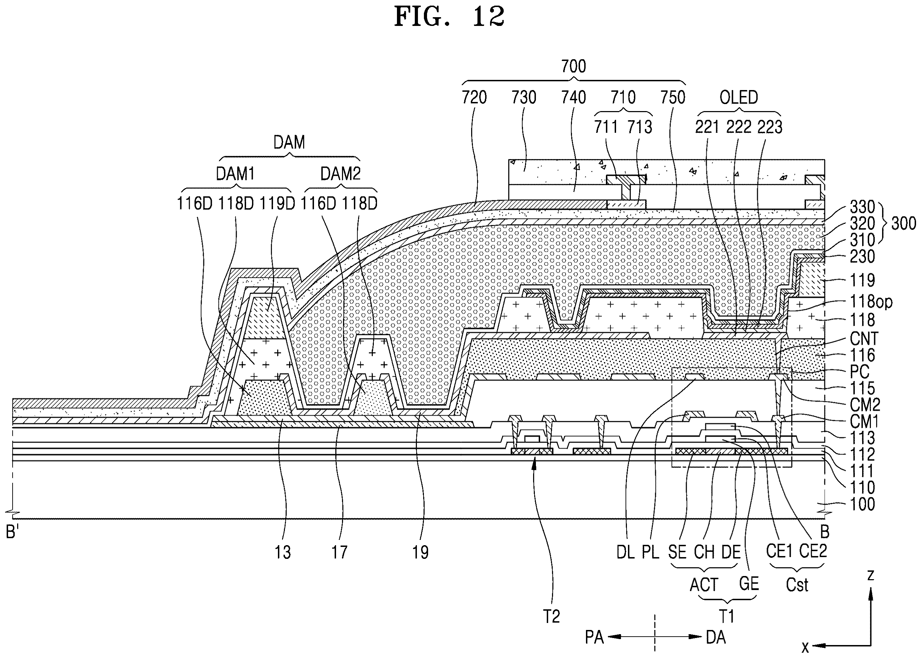

FIG. 12 is a cross-sectional view of the display panel, taken along a line B-B' of FIG. 7.

Referring to FIG. 12, the peripheral area PA may correspond to a portion located on the left side or right side of the display area DA shown in FIG. 7. The first scan driving circuit may include a plurality of second TFTs T2 and lines (not shown) connected to the second TFTs T2. The second TFT T2 may be formed through the same process as the first TFT T1 of the sub-pixel circuit PC, and thus, the detailed descriptions regarding the second TFT T2 are omitted. Although not shown, control signal lines configured to apply control signals to the first scan driving circuit may be further arranged in the peripheral area PA. The control signal lines may include signal lines configured to apply a clock signal, an inverted clock signal, a carry signal, and the like. The control signal line may be arranged on (e.g., formed on) the same layer as the semiconductor layer ACT, the gate electrode GE, the upper electrode CE2 of the storage capacitor Cst, or the driving voltage line PL.

As shown in FIG. 12, the common voltage supply line 13 may be arranged in the peripheral area PA located on the left side, right side, and upper side of the display area DA. The common voltage supply line 13 may be arranged in the peripheral area PA.

A plurality of holes may be defined in the common voltage supply line 13 arranged in the peripheral area PA. The holes may function as outgassing paths through which gas generated from the first insulating layer 115 is discharged outside, thereby preventing or reducing the degradation in image quality on a display panel caused by the penetration of gas or moisture from the first insulating layer 115 into the display area DA. Although not shown, holes may also be defined in the common voltage supply line 13 arranged on (e.g., formed on) the upper side of the substrate 100 in a region adjacent to the display area DA. The common voltage supply line 13 may include the same material as one of the lines arranged between the first insulating layer 115 and the second insulating layer 116 in the display area DA. For example, the common voltage supply line 13 may include the same material as the data line DL arranged on (e.g., formed on) the first insulating layer 115 in the display area DA. The common voltage supply line 13 may be arranged on (e.g., formed on) the same layer and include the same material as the driving voltage supply line 30. The driving voltage supply line 30 and the common voltage supply line 13 may be spaced apart from each other on the same layer.

In a peripheral area PA, a voltage line 17 may be further arranged between the common voltage supply line 13 and the interlayer insulating layer 113. A portion of the common voltage supply line 13 arranged in the peripheral area PA may overlap and directly contact the voltage line 17. The voltage line 17 may include the same material as one of the lines arranged between the interlayer insulating layer 113 and the first insulating layer 115 in the display area DA. For example, the voltage line 17 may include the same material as the driving voltage line PL arranged on (e.g., formed on) the interlayer insulating layer 113 in the display area DA. The common voltage supply line 13 may be configured to transmit the second power voltage ELVSS, which is applied from the voltage line 17, to the pixel electrode 221 through an auxiliary line 19.

The auxiliary line 19 may be arranged in the peripheral area PA. A portion of the auxiliary line 19 arranged in the peripheral area PA may be connected to the opposite electrode 223. For example, the opposite electrode 223 may directly contact the auxiliary line 19 exposed through the hole defined in the third insulating layer 118 arranged in the peripheral area PA. In the peripheral area PA, a portion of the auxiliary line 19 may overlap and directly contact the common voltage supply line 13. In the peripheral area PA, a portion of the auxiliary line 19 may be arranged between a plurality of layers forming the dam of the dam portion DAM. In the auxiliary line 19 located inside the dam portion DAM, a hole exposing a portion of the upper surface of the layer arranged under the auxiliary line 19 may be defined. The auxiliary line 19 may include the same material as one of the lines arranged between the second insulating layer 116 and the third insulating layer 118 in the display area DA. For example, the auxiliary line 19 may include the same material as the pixel electrode 221 arranged on (e.g., formed on) the second insulating layer 116 in the display area DA.

The common voltage supply line 13 may be located on the upper portion of the inorganic layer. For example, the common voltage supply line 13 may be arranged on (e.g., formed on) an inorganic insulating layer that includes at least one of the buffer layer 110, the first gate insulating layer 111, the second gate insulating layer 112, and the interlayer insulating layer 113.

When the organic encapsulation layer 320 is formed, it may be beneficial that the material for forming the organic encapsulation layer 320 be confined within a desired and/or alternatively predetermined region. To this end, the dam portion DAM including at least one dam may be included in the peripheral area PA. The dam portion DAM may be provided in the form of a line surrounding the display area DA. That is, the dam portion DAM may form a closed loop, and in a plan view, the display area DA may be arranged in the dam portion DAM. FIG. 9 illustrates two dams, that is, the first dam DAM1 and the second dam DAM2. The number of dams included in the dam portion DAM may change. The first dams DAM1 and the second dam DAM2 may be arranged between the display area DA and the terminal portion 20 (see FIG. 7) of the substrate 100. The first dam DAM1 and the second dam DAM2 may be arranged on (e.g., formed on) the inorganic layer. For example, the first dam DAM1 and the second dam DAM2 may be arranged on (e.g., formed on) the inorganic insulating layer including at least one of the buffer layer 110, the first gate insulating layer 111, the second gate insulating layer 112, and the interlayer insulating layer 113.

The first inorganic encapsulation layer 310 and the second inorganic encapsulation layer 330 may cover the first dam DAM1 and the second dam DAM2 and may be formed to the outer sides of the first dam DAM1 and the second dam DAM2. The organic encapsulation layer 320 may be confined by the first dam DAM1 and the second dam DAM2, which limits and/or prevents the material for forming the organic encapsulation layer 320 from overflowing beyond the outer sides of the first dam DAM1 and the second dam DAM2.

At least a portion of the first dam DAM1 and the second dam DAM2 may be arranged on (e.g., formed on) power supply lines, for example, on the upper portion of the common voltage supply lines 13. The first dam DAM1 and the second dam DAM2 may extend from the lower side of the display area DA to the peripheral area PA in the x direction (see FIG. 7). The first dam DAM1 and the second dam DAM2 may extend from the left side and the right side of the display area DA to the peripheral area PA in the y direction. Although not shown, the first dam DAM1 and the second dam DAM2 may extend from the upper side of the display area DA to the peripheral area PA in the x direction.

Each dam portion DAM may have a multilayered structure including a plurality of layers. To allow the dam portion DAM to limit the location of a material for forming an organic encapsulation layer, it is advantageous to form the first dam DAM1, which is on the outermost side, to have a relatively greater height than the second dam DAM2. The dam portion DAM may include a greater number of layers so that the height of the first dam DAM1, which is located on the outermost side from the display area DA, is greater than that of the second dam DAM2. For example, the second dam DAM2 may include two layers: a first layer 116D, which is the lowermost layer, and a second layer 118D on the first layer 116D which are stacked in a direction away from the upper surface of the substrate 100, that is, the z direction. The first dam DAM1 may include three layers stacked in the z direction: a first layer 116D that is the lowermost layer; a second layer 118D on the first layer 116D; and a third layer 119D on the second layer 118D.

Each dam may include a plurality of organic insulating layers. For example, the first layer 116D may be simultaneously formed of the same material as the second insulating layer 116 when the second insulating layer 116 is formed in the display area DA. The second layer 118D may be simultaneously formed of the same material as the third insulating layer 118 when the third insulating layer 118 is formed in the display area DA. The third layer 119D may be simultaneously formed of the same material as the spacer 119 when the spacer 119 is formed in the display area DA.

As shown in FIG. 12, the auxiliary line 19 may be arranged between the first layer 116D and the second layer 118D of the first dam DAM1 and the second dam DAM2 and may be configured to cover the first layer 116D. In the auxiliary line 19, a hole exposing a portion of the upper surface of the first layer 116D may be defined. The hole may function as an outgassing path through which gas generated from the first layer 116D is discharged to the outside.

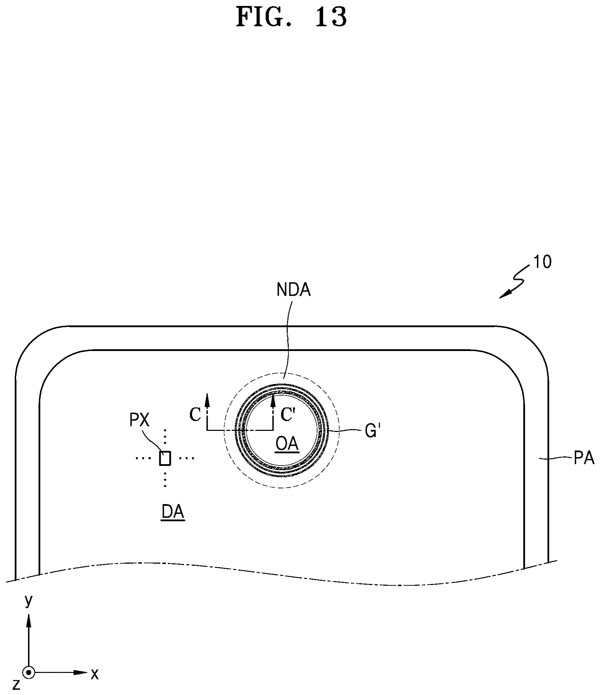

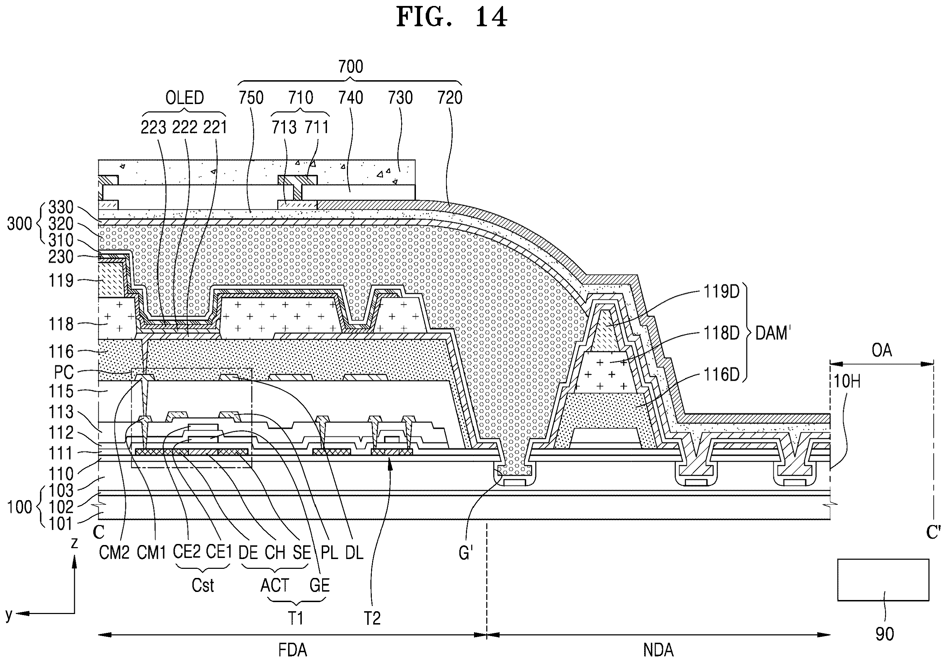

FIG. 13 is a schematic plan view of a portion of a display panel according to another embodiment. FIG. 14 is a cross-sectional view of the display panel, taken along a line IV-IV' of FIG. 13. The same reference numerals in FIGS. 9 and 14 denote the same elements.

Referring to FIGS. 13 and 14, the display panel 10 according to an embodiment may include the display area DA and the peripheral area PA, as shown in FIG. 6A, 6B, or 7. The display panel 10 may include an opening area OA located inside the display area DA and a non-display area NDA surrounding the opening area OA.

In the display area DA, a plurality of sub-pixels PX may be arranged apart from each other. The display area DA may form a single plane. In addition, the opening area OA may be located inside the display area DA.

The opening area OA may be in various planar shapes, such as a circle, an oval, a polygon such as a square, a star, or a diamond. Moreover, the location of the opening area OA may also be variously modified. For example, as shown in FIG. 12, the opening area OA may be arranged at the upper center of a front display area FDA, or unlike what is shown in the drawing, the opening area OA may be at various locations, for example, the right center or the left center of the front display area FDA.

As shown in FIG. 14, a component 90 that is an electronic component may be arranged under the display panel 10, the component 90 corresponding to the opening area OA. The component 90 may be a camera using infrared light or visible light and may include an imaging device. Alternatively, the component 90 may be a solar cell, a flash, an illuminance sensor, a proximity sensor, or an iris sensor. Alternatively, the component 90 may have a sound-receiving function.

Referring back to FIG. 13, the non-display area NDA may surround the opening area OA. The non-display area NDA may be an area where no display elements, such as light-emitting diodes emitting light are arranged, and in the non-display area NDA, signal lines configured to provide signals to the sub-pixels PX provided around the opening area OA may pass through or an additional groove G' may be arranged.

FIG. 13 illustrates that three additional grooves G' are located in the non-display area NDA, but one or more embodiments are not limited thereto. In another embodiment, one, two, or four or more grooves may be arranged in the non-display area NDA.

The additional grooves G' may each have a loop shape that entirely surrounds the opening area OA in a non-display area NDA. The diameter of each additional groove G' may be greater than that of the opening area OA. In a plan view, the additional grooves G' surrounding the opening area OA may be spaced apart from each other at certain intervals.

Referring to FIG. 14, the display panel 10 may include a first opening 10H corresponding to the opening area OA. The organic light-emitting diode OLED that is a display element may be arranged in the display area DA, and the opposite electrode 223 of the organic light-emitting diode OLED may extend to the non-display area NDA.

The substrate 100 may include a first substrate base layer 101, a barrier layer 102, and a second substrate base layer 103. In this case, the first substrate base layer 101, the barrier layer 102, and the second substrate base layer 103 may be the same as or similar to those described above with reference to FIG. 9.

In the non-display area NDA, a plurality of additional grooves G' may be arranged. The additional groove G' may be formed by spatially connecting a recess formed by removing a portion of the second substrate base layer 103 of the substrate 100 to a hole penetrating the first gate insulating layer 111 and the second gate insulating layer 112.

The first gate insulating layer 111 and the second gate insulating layer 112 may each include a protruding tip that protrudes towards the additional groove G'. The protruding tips of the first gate insulating layer 111 and the second gate insulating layer 112 may cause a disconnection of the opposite electrode 223 and a portion of the intermediate layer 222, which may be included in the organic light-emitting diode OLED, around the additional groove G'.

The first inorganic encapsulation layer 310 of the encapsulation layer 300 may exhibit relatively greater step coverage than the opposite electrode 223. Therefore, the first inorganic encapsulation layer 310 may be continuously formed without being disconnected at the additional groove G'.

An additional dam DAM' may be arranged in the non-display area NDA and may block the flow in the organic encapsulation layer 320. The additional dam DAM' may include a first layer 116D, a second layer 118D, and a third layer 119D. In this case, the first layer 116D, the second layer 118D, and the third layer 119D may be the same as or similar to those described above with reference to FIG. 9. The first inorganic encapsulation layer 310 and the second inorganic encapsulation layer 330 may contact each other between the additional dam DAM' and the opening area OA.

The input detection layer 700 may be arranged in a display area DA (not shown) and the non-display area NDA. In this case, the input detection layer 700 may include a touch buffer layer 750, a first touch conductive layer 711, a second touch conductive layer 713, a first touch insulating layer 730, a second touch insulating layer 740, and a touch line 720.

In the above case, the touch line 720 may extend from the display area DA to the non-display area NDA. In this case, as the additional dam DAM' is formed similarly or identically to the first dam and/or the second dam described above, the additional dam DAM' may reduce possible connections between adjacent touch lines 720. Also, the taper angle of the side surface of the additional dam DAM' may be adjusted by setting the taper angle of the second gate insulating layer 112 and/or the interlayer insulating layer 113 arranged within the additional dam DAM' differently from that of the second gate insulating layer 112 and/or the interlayer insulating layer 113 arranged in the display area DA. In this case, the taper angles of the contact holes arranged in the display area DA and the non-display area NDA and formed in the same layer or the taper angle of the side surfaces of the same layer may be greater in the layer arranged in the display area DA than the layer arranged in the non-display area NDA.

According to the one or more embodiments, a display panel and an electronic device may have fine patterns for providing clear images.

According to the one or more embodiments, a display panel capable of reducing malfunction may be manufactured according to a method of manufacturing the display panel.

One or more of the elements disclosed above may include or be implemented in processing circuitry such as hardware including logic circuits; a hardware/software combination such as a processor executing software; or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. A display panel (10) comprising:
a substrate (100) including a display area (DA) and a non-display area (PA), the non-display area (PA) surrounding at least a portion of the display area (DA) or the non-display area (PA) being at least partially surrounded by the display area (DA);
a display layer on the substrate (100); and
an encapsulation layer (300) on the display layer, wherein
the display layer comprises a first layer (116D) on the display area (DA) and the non-display area (PA), and
a taper angle of one surface of the first layer (116D) on the display area (DA) is greater than a taper angle of one surface of the first layer (116D) on the non-display area (PA).

2. The display panel (10) of claim 1, wherein the first layer (116D) comprises an insulating material, a conductive material, or both the insulating material and the conductive material.

3. The display panel (10) of claim 1 or 2, further comprising:
a dam (DAM) on the non-display area (PA), wherein
the dam (DAM) comprises the first layer.

4. The display panel (10) of claim 3, wherein
the display layer includes an organic insulating layer (116) on the display area (DA), the first layer (116D) of the dam (DAM) comprises a same material as the organic insulating layer (116) on the display area (DA), and
a taper angle of an inclined surface of the first layer (116D) is less than a taper angle of an inclined surface of the organic insulating layer (116).

5. A method of manufacturing a display panel (10), the method comprising:
arranging a first base layer (BMT) on a substrate (100), the substrate (100) including a display area (DA) and a non-display area (PA), the non-display area (PA) surrounding at least a portion of the display area (DA) or the non-display area (PA) being at least partially surrounded by the display area (DA);
arranging photoresist (PR1) on the first base layer (BMT);
forming the photoresist (PR1) into patterns of the photoresist (PR1) spaced apart from each other;
irradiating ultraviolet light onto the photoresist (PR1) on the non-display area (PA) and applying a shrinkage-inducing material (RET) over the photoresist (PR1) on the display area (DA) and the non-display area (PA);
applying heat to the shrinkage-inducing material (RET) and then removing the shrinkage-inducing material (RET) from the photoresist (PR1); and
heating the photoresist (PR1).

6. The method of claim 5, further comprising:
rinsing the shrinkage-inducing material (RET) using ultrapure water before the removing the shrinkage-inducing material (RET).

7. The method of claim 5 or 6, wherein the removing the shrinkage-inducing material (RET) from the photoresist (PR1) includes:
removing the shrinkage-inducing material (RET) from the photoresist (PR1) on the display area (DA) and removing some of the shrinkage-inducing material (RET) from the photoresist (PR1) on the non-display area (PA) such that a portion of the shrinkage-inducing material (RET) remains on the photoresist (PR1) on the non-display area (PA) before the heating the photoresist (PR1).

8. The method of any one of claims 5 to 7, wherein a first inclination angle (θa) of a surface of the photoresist (PR1) on the display area (DA) is different from a second inclination angle (θb) of a surface of the photoresist (PR1) on the non-display area (PA), and/or wherein the first inclination angle (θa) is greater than the second inclination angle (θb).

9. The method of any one of claims 5 to 8, further comprising:
forming a first layer (116D) by etching the first base layer (BMT), wherein at least a portion of the first layer (116D) is spaced apart from an other portion of the first layer (116D).

10. The method of claim 9, wherein a taper angle of a surface of the first layer (116D) on the display area (DA) is different from a taper angle of a surface of the first layer (116D) arranged on the non-display area (PA).

11. The method of claim 9 or 10, wherein the first layer (116D) is formed by dry-etching the first base layer (BMT).

12. The method of any one of claims 9 to 11, further comprising:
arranging a second base layer (116B) on the first layer (116D); and
forming a second layer (118D) by removing a portion of the second base layer (116B).

13. The method of any one of claims 5 to 12, further comprising:
removing the photoresist (PR1), and /or
arranging an encapsulation layer (300) on the display area (DA).

14. The method of claim 13, further comprising:
arranging an input detection layer (700) on the encapsulation layer (300), the input detection layer (700) comprising at least one electrode (710).

15. An electronic device (1, 1_1, 1_2, 1_3) comprising:
a display panel according to any one of claims 1 to 4 or a display panel manufactured according to the method of any one of claims 5 to 14, and
a battery (5) connected to the display panel (10).
